(19) Europäisches Patentamt
European Patent Office
Office européen des brevets

(11) **EP 0 588 307 B1**

(12) **EUROPEAN PATENT SPECIFICATION**

(45) Date of publication and mention
of the grant of the patent:
**08.12.1999 Bulletin 1999/49**

(51) Int Cl.[6]: **H03M 13/00, H04Q 7/20**

(21) Application number: **93114769.8**

(22) Date of filing: **14.09.1993**

(54) **System for transmitting information bit sequences**

System für Übertragung von Informationsbitfolgen

Système de transmission des séquences de bits d'information

(84) Designated Contracting States:
**DE FR GB SE**

(30) Priority: **14.09.1992 JP 24512992**

(43) Date of publication of application:
**23.03.1994 Bulletin 1994/12**

(73) Proprietor: **NTT MOBILE COMMUNICATIONS
NETWORK INC.
Minato-ku, Tokyo (JP)**

(72) Inventors:
• **Suda, Hirohito
  Yokosuka-shi, Kanagawa-ken (JP)**
• **Matsumoto, Tadashi
  Yokosuka-shi, Kanagawa-ken (JP)**
• **Takami, Tadao
  Yokosuka-shi, Kanagawa-ken (JP)**

(74) Representative:
**Brandl, Ferdinand Anton, Dipl.-Phys.
Winter, Brandl, Fürniss, Hübner, Röss,
Kaiser, Polte, Kindermann
Partnerschaft
Patent- und Rechtsanwaltskanzlei
Alois-Steinecker-Strasse 22
85354 Freising (DE)**

(56) References cited:
**EP-A- 0 477 377          US-A- 5 136 592**

• **IEEE Veh. Tech. Conf., 1985 P.J. MABEY " Mobile
  Digital Transmission with Soft Decision
  Decoding", pages 197-199**
• **IEEE Transactions on Information Theory, vol.
  IT-10, no. 2, April 1964 T. KASAMI "A Decoding
  Procedure for Multiple- -Error-Correcting Cyclic
  Codes" pages 134-138**

## Description

The present invention relates to an information bit sequence transmitting system typically represented by a mobile radio system, such as a digital land mobile radiotelephone system and hand-held telephone system.

The mobile radio system, such as a digital land mobile radiotelephone system and hand-held telephone system, is known as one of information systems which has frequently encountered a random/burst-compounded error. In such a transmission system, such a random/burst-compounded error has frequently been encountered on a transmitting channel. It has been difficult, in the transmission system, to achieve effective error correction simply through random error correction decoding. For this type of transmission system, however, a bit-interleaving/random error correction coding - combined technique has been employed to realize effective error correction.

On the other hand, the cyclic code has such a property that a given code word, being cyclically permutated, also gives a code word. Mabey has proposed trying to apply burst error correction decoding to this type of transmission system through the utilization of that property of the cyclic code ("Mobile Digital Transmission with Soft Decision Decoding", IEEE Veh. Tech. Conf., 1985, pp.197-199). The burst error correction decoding technique of Mabey utilizes reliability information obtained at a receiver. That is, using the reliability information obtained from a receiver, the Mabey's technique extracts, out of received words, those cyclically continuous k bits of the highest reliability and reproduces a transmit sequence by coding the extracted k bits. It is to be noted that the burst error correction decoding technique of Mabey is based on the assumption that no error occurs in the cyclically continuous k bits of the highest reliability.

In the aforementioned bit-interleaving/random error correction coding - combined technique, the burst error is randomized by making the bit interleaving length adequately long. It is possible to achieve effective random error correction coding by applying the bit interleaving/random error correction coding - combined technique to this type of transmission system.

However, the aforementioned bit interleaving/random error correction coding - combined technique cannot satisfy the error correction capability and shortening of a delay time simultaneously. This is because the bit interleaving length has to be made adequately long in order to exhibit a high error correction capability. It is, therefore, not possible to expect the shorting of that delay time. The technique, being applied to the mobile radio system such as the digital land mobile radiotelephone system and hand-held telephone system, presents the following drawbacks. In this type of mobile radio system, those signals to be transmitted or received comprise control signals and speech signals. Of the control signals and non-control signals (speech signals), the control signals in particular which give various controls, such as to establish a circuit connection, have their transmit/receive delay times made as short as possible upon transmission and reception. If the technique cannot achieve the shorting of the delay time even in the case where it can exhibit a high error correction capability, the technique is not desirable in this type of mobile radio system. If, on the other hand, the bit interleaving length is restricted to about tens of ms so as to realize the shorting of the delay time, then it is not possible to achieve adequate randomization of the burst error and hence to effectively utilize the random error correction cording capability of the technique above. This is the reason why the technique is not desirable in this type of mobile radio system.

Further, since the Mabey's burst error correction decoding technique is based on the assumption that no error occurs in the cyclically continuous k bits of the highest reliability, a correction error is produced if there occurs any error in the k bits. Stated in another word, the correction error probability is increased because the Mabey's burst error correction decoding technique makes burst error correction with the use of the reliability information alone.

Further, the Mabey's technique can make error correction if only one burst error is contained in the code involved. It is, therefore, difficult to make error correction if a plurality of mixed burst errors and/or random errors are involved in the code. It is also difficult to make error correction by the burst error correction decoding method because, in particular, mixed random errors and burst errors occur in a transmitting channel of the mobile radio system and a plurality of errors are involved in the same code.

From US-A-5 136 592 an error detection and correction system is known which encodes data twice for error detection using a CRC code and for error correction using a Reed-Solomon code. Errors which are detected are corrected by using error location information of both codes. The data is encoded twice, once vertically for error detection and once horizontally for error correction. The system is able to detect random errors as well as burst errors.

From EP-A-0 477 377 a system according to the preamble of claim 1 is known. In more detail, this document describes an error detection method which uses an error detection code (CRC code) and an error correction code. The error detection code can be a combination of a CRC code and a BCH code. An advantage of the method is that the error which cannot be detected by the CRC code can be surely detected. Data including errors is subjected to an interpolation processing, for example this data is muted.

It is accordingly the object of the present invention to provide an information bit sequence transmitting system which, when information bit sequences are transmitted, can reduce an increase in error correction probability and more efficiently achieve error correction decoding than the conventional counterpart can.

This object is solved by the subject matter of claim 1.

In more detail, at a transmitting side, the information bit sequence is subjected to error detection coding processing with the use of an CRC code, etc.; and after performing error correction coding with the use of a cyclic code, corresponding bits are transmitted. At the receiving side, both cyclic code random error correction decoding and burst error correction decoding processings are performed on the code sequences and a result of decoding is subjected to error detection checking with a CRC code, etc., to obtain a final result of decoding.

By such cyclic code random error correction decoding and burst error correction decoding processings, those received sequences are basically decoded as many as practical. In order to alleviate an increase in undetectable errors, error detection decoding is also used with an very effective CRC code, etc., and, if the present system is applied to a random error/burst error-mixed transmission path for a mobile radio system, it is possible to achieve effective error correction and reduce an undetected error percentage.

Further advantageous modifications of the present invention are subject matter of the depending claims.

This invention can be more fully understood from the following detailed description when taken in conjunction with the accompanying drawings, in which:

Fig. 1 is a block diagram showing one form of a radio transmitting system to which the present invention is applied;

Fig. 2 is a block diagram showing a major section of the radio transmitting system in Fig. 1;

Fig. 3 is a block diagram showing a major part of a system according to a first embodiment of the present invention;

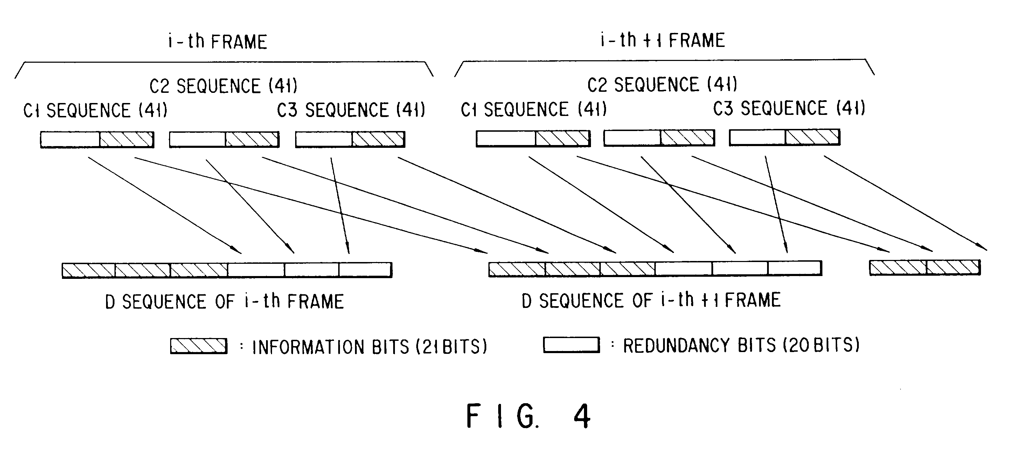

Fig. 4 is a view showing a detail of an interleaving section in Fig. 3;

Fig. 5 is a block diagram showing a detail of a decoder in Fig. 3;

Fig. 6 is a block diagram showing a detail of a random error correction decoding section in Figs. 3 and 5;

Fig. 7 is a block diagram showing a detail of a burst error correction decoding section in Figs. 3 and 5;

Fig. 8 is a block diagram showing a major section of a system according to a second embodiment of the present invention;

Fig. 9 is a block diagram showing a detail of a first form of a decoder in Fig. 8;

Fig. 10 is a block diagram showing a detail of a second form of a decoder in Fig. 8;

Fig. 11 is a block diagram showing a detail of a third form of a decoder in Fig. 8;

Fig. 12 is a block diagram showing a major section of a system according to a third embodiment of the present invention;

Fig. 13 is a block diagram showing a detail of a decoder in Fig. 12;

Fig. 14 is a characteristic curve comparing the present invention and a conventional method in terms of soft and hard decisions; and

Fig. 15 is a view showing a detail of a relationship of Ji and I$\ell$.

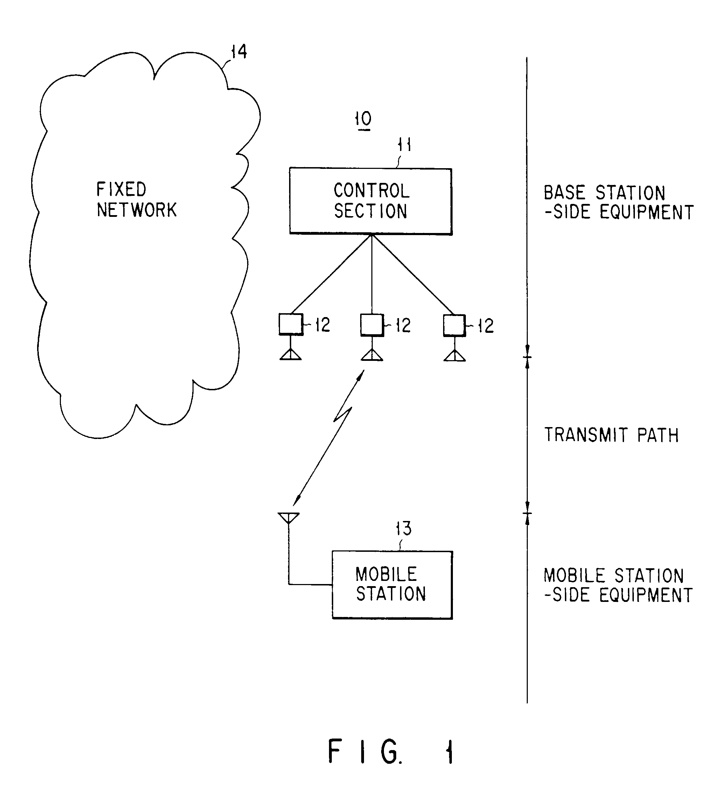

An information bit sequence transmitting system of the present invention is typically represented by a mobile radio system such as a digital land mobile radio-telephone system and hand-held telephone system. The mobile radio system is diagrammatically understandable with reference to Fig. 1. As shown in Fig. 1, a mobile network 10 is defined by a base station-side equipment comprising a control station 11 and base stations 12, a transmitting channel, and a mobile station-side equipment (mobile stations such as hand-held telephones). The mobile network 10 is normally connected to a fixed network 14 such as a general public-switched telephone network. Mutual communication is carried out between the mobile station 13 and the base stations 11 via a radio transmission channel constituting an antenna. The communication between one mobile station and another mobile station or between one mobile station and the general public-switched telephone network in the fixed network is conducted through a signal transfer between the mobile station and a ground equipment comprising the control station and base stations. In a mobile radio system typically represented by such a mobile telephone system a demand is made for information bit sequence low-delay transmission (delay-time reduction) and high accuracy transmission. According to the present invention it is possible to achieve information bit sequence signal low-delay transmission (delay-time reduction) and high accuracy transmission with the use of the coding/decoding technique.

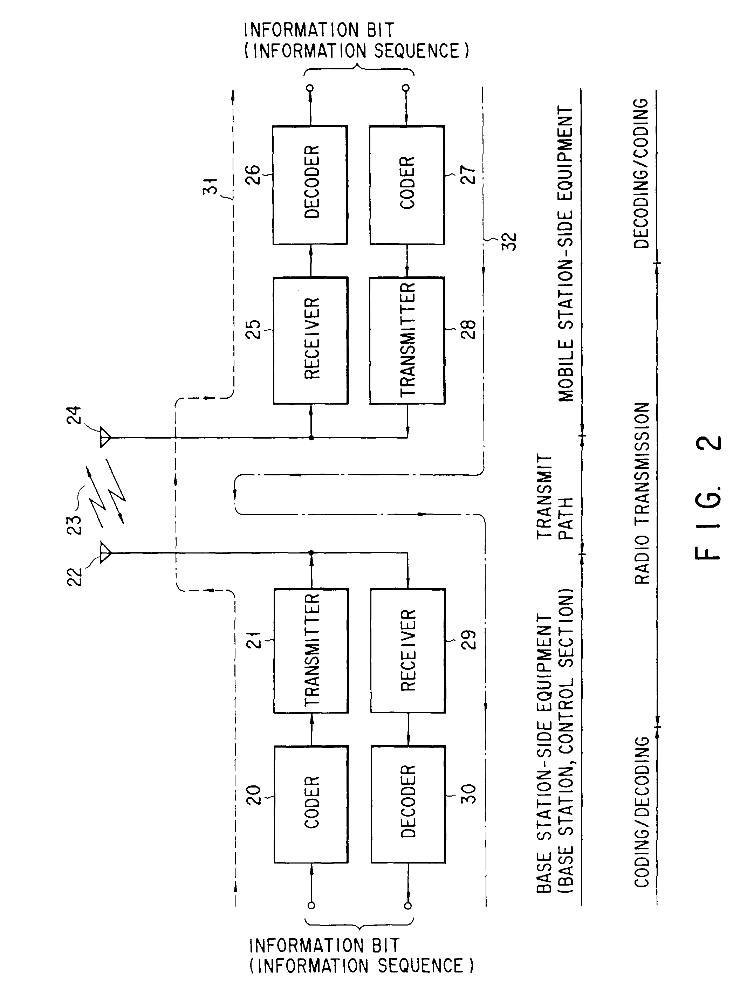

As shown in Fig. 2, a base station-side equipment, a transmission path 23 and a mobile station-side equipment in the mobile radio system to which the present invention is applied are defined. The base station-side equipment includes a coder 20, a transmitter 21, an antenna 21, an antenna 22, a receiver 29 and decoder 30. The mobile station-side equipment includes an antenna 24, a receiver 25, a decoder 26, a coder 27 and a transmitter 28. The signal transmission from the base station side to the mobile station is achieved through a channel 31 and the signal transmission from the mobile station side to the base station side is achieved through a channel 32. Even if any of the channels 31 and 32 is established, the system performs the coding/decoding, radio transmission and coding/decoding of information bit sequences in a reversible way.

A system according to a first embodiment of the present invention transmits an information bit sequence (53 bits) as an A sequence with the use of a coding/decoding technique and includes a coder 20 (or 27), a radio transmission path 45 (a transmitter 21, an antenna 22, a transmission path 23, an antenna 24, a receiver 25, a transmitter 28 and a receiver 29) and a decoder 26 (or 30).

The system of the first embodiment has a coder 20 (or 27) including a CRC coding section 41, a dividing section 42, BHC coding section 43 and an interleaving section 44. The decoder 26 (or 27) of the present system includes a deinterleaving section/dividing section 46, random error correction decoding sections 47, burst error correction decoding sections 48, a synthesizing section 49, a CRC error detection decoding section 50 and a selection section 51.

The respective portions of the first embodiment will be explained below. First, the coder 20 (or 27) will be explained below. That is, the error detection coding section 41 is of such a type that, in order to generate a B sequence comprising information bits and redundancy bits for error detection coding, the error detection coding section 41 performs the CRC coding of the information bit sequence given as the A sequence. The dividing section 42 divides the B sequence into K parts in order to generate Bi sequences (i = 1 to k, ni: a bit length of the respective sequence). The BCH coding sections perform the BCH coding of the Bi sequences in order to generate Ci sequences. The interleaving section 44 interleaves the Ci sequences in order to generate a D sequence.

The transmission sequence 45 constitutes a radio transmission section for the mobile radio system.

The decoder 26 (or 37) will now be explained below. That is, the deinterleaving section of the deinterleaving/dividing section 46 is of such a type that, in order to generate Ei sequences, it deinterleaves the E sequence corresponding to the D sequence received via the transmission path. The dividing section of the deinterleaving/dividing section 46 divides the Ei sequences into K parts corresponding to the cyclic code. The random error correction decoding sections 47 perform the random error correction decoding of the cyclic code in order to generate $F_{i,1}$ sequences. The burst error correction decoding section 48 performs the cyclic code burst error correction decoding of the Ei sequence in order to generate $H_{i,j(i)}$ sequences (ni: a bit length of the respective sequence). Here the burst error correction decoding section 48 performs the processing for selecting cyclically continuous ni number of information bits out of the Ei sequence, processing for generating an E1i sequence through the application of the cyclic code generator polynomial to the information bits and processing for generating an E2i sequence of ni bits corresponding to the Bi sequence through the cyclic shifting of the E1i sequence, that is, performs these processings by repeating them in a sequential bit position displacing fashion and generates an Hi sequence corresponding to the sequence Ei. In this connection it is to be noted that the Hi sequence is given by

$$H1 = H_{1,1}, H_{1,2}, ..., H_{1,j(1)}$$

$$H2 = H_{2,1}, H_{2,2}, ..., H_{2,j(2)}$$

$$H3 = H_{3,1}, H_{3,2}, ..., H_{3,j(3)}$$

$$H_k = H_{k,1}, H_{k,2}, ..., H_{k,j(k)}$$

A synthesizing section 49, a CRC code error detection decoding section 50, and a maximum likelihood decoding selection section 51 are provided as a final decoding means. The synthesizing section 49 and maximum likelihood decoding selection section 51 generate first decoding candidates corresponding to the Bi sequence by selecting out of the Fi and $H_{i,1}, H_{i,2}, ..., H_{i,j(i)}$ sequences a (1 + j(i)) number of these sequences and generate second decoding candidates Ik (k = 1 to K, k = 1 to K, a maximum of K is $\Pi i$ (1 + j(i)) corresponding to the B sequence from combinations of the first decoding candidates. The CRC code error detection coding section performs the error detection decoding of the second decoding candidates Ik and generates a decoding result of the information bit sequence corresponding to the A sequence.

The random error correction decoding section 47 includes a means for generating an f(i) number of the Fi sequences as decoding candidates corresponding to the respective Ei sequence by a soft decision decoding using reliability information obtained at the receiving side. The burst error correction decoding section 48 includes a means for generating a j2(i) number of the Hi sequences out of those cyclically continuous ni bits in the Ei sequence and those inverted bit sequence corresponding to these bits of relatively low reliability in the Ei series with the use of the generator polynomial of the cyclic code. The synthesizing section 49 includes a means for generating an (f(i) + j2(i)) number of decoding candidates corresponding to the Ei 4 sequence and generating decoding candidates 1k (k = 1 to K, a maximum of K is $\Pi i4j3(i)$) corresponding to the B sequence by selecting a j3(i) number of decoding candidates out of the (f(i) + j2(i)) number of decoding candidates in an increasing reliability order. The CRC code error detection decoding section 50 and maximum likelihood decoding section 51 include a means which, when the decoding candidate Ik, being subjected to an error detection decoding, is decided as being only one and containing no error, selects that decoding candidate as a result of decoding the information bit sequence and, when a plurality of decoding candidates are decided as containing no error, selects the highest decoding candidate, as a result of decoding the information bit sequence in the A sequence, by comparing the decoding candidates in terms of their reliability.

The operation of the present system thus arranged will be explained below principally in conjunction with the error correction and detection coding and decoding technique. The present system codes a 53 bit-long information bit sequence (a sequence) and transmits it.

First, the transmit side performs the CRC coding of the aforementioned information bit sequences with the use of a 10 bit CRC code for error detection coding processing and generates a 63-bit B sequence (CRC decoding section 41).

Then the B sequence is divided into k = 3 parts and generates Bi (i = 1 to 3) sequences each having 21 bits - dividing section 42.

Then the Bi sequence is subjected to coding processing with the use of 3 BHC (41, 21) code as the cyclic code to generate a Ci sequence (BCH coding section). The BCH code represents 21 bits as a respective information bit, 41 bits as a code length and 41 bits as the Ci sequence.

Then the Ci sequence is further subjected to bit interleaving processing and is transmitted as a D sequence via the transmission path (interleaving section 44, radio transmission section). Here bit interleaving processing is performed on two Ci sequences, that is, on the i-th frame and (i-th + 1) frame, and the system transmits a information bit part and redundancy bit part as one unit.

On the other hand, the receiving side performs deinterleaving processing, as distinct from the bit interleaving processing, on the sequence received through the transmission path, divides the received sequence into three code words corresponding to the BCH code and generates an Ei sequence (each sequence is 41 bits long) corresponding to the Ci sequence on the transmission side - deinterleaving section/dividing section 46. Here the Ci sequence and Ei sequence completely coincide with each other if they contain no error on the transmission path.

Random error correction decoding processing and burst error correction decoding processing are simultaneously performed on the Ei sequence to generate Fi and Hi sequences - random error correction decoding section 47 and burst error correction decoding section 48. On the three Ei sequences, the same decoding processing is performed.

Here, the burst error correction decoding processing is performed in the following way. That is, the burst error correction decoding processing comprises generating a Gi1 sequence by selecting an ni number of cyclically continuous bits out of each Ei sequence and performing the cyclic coding with the use of the same generator polynomial equation as in the coding of the n bits by the BCH coding section 43 as the information bits and generating an Hi1 sequence comprised of an ni number of bits in a part corresponding to a Bi sequence by cyclically shifting the Gi1 sequence. Then similar processing is performed by selecting an ni number of cyclically continuous bits, as different bits, out of the Ei sequence. In this way, a Gi2 sequence and Hi2 sequence are generated. Similarly, the Gi1 sequence and Hi1 sequence are repeated while sequentially displacing the position of the ni number of bits to eventually generate an Hi sequence having the following relation for the Ei sequence:

$$H1 = H_{1,1}, H_{1,2}, ..., H_{1,j(1)}$$

$$H2 = H_{2,1}, H_{2,2}, ..., H_{2,j(2)}$$

$$H3 = H_{3,1}, H_{3,2}, ..., H_{3,j(3)}$$

$$........$$

$$HK = H_{k,1}, H_{k,2}, ..., H_{k,j(k)}$$

The synthesizing section 49 synthesizes the Fi and Hi sequences obtained from the random error correction decoding section 47 and burst error correction decoding section 48. In the synthesizing section 49, a(1 + j(i)) number of Fi and $H_{i,1}, H_{i,2}, ..., H_{i,j(i)}$ are selected as decoding candidates for the Bi sequence to generate an Ik sequence (k = 1 to K, a maximum of K is ni (1 + j (i)) as a decoding candidate for the B sequence through a combination of the aforementioned decoding candidates. The burst error correction decoding processing are performed in this way.

The CRC error detection decoding section 50 performs error detection decoding for the Ik sequence from the synthesizing section 49 with the use of a CRC code. Here the selection section 51 is so operated that, when, as a result of such error detection coding, that decoding candidate is decided as being only one and containing no error, the selection section 51 selects the decoding candidate as a result of decoding the information bit sequence and, when a plurality of decoding candidates are decided as containing no error, selects an information bit sequence of highest reliability, as a result of decoding the information bit sequence, upon comparison with the plurality of decoding candidates. By so doing, the selection section 51 obtains a final result of decoding.

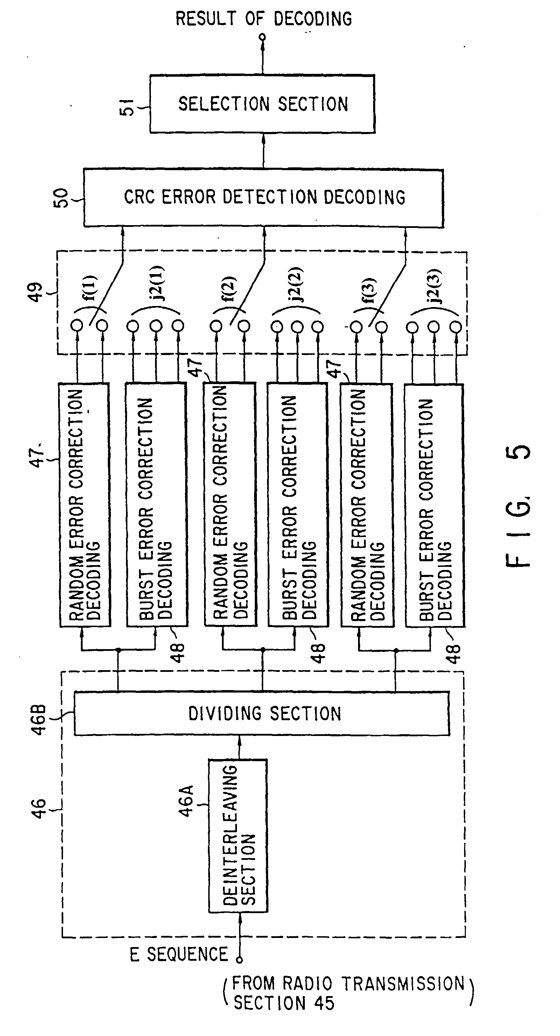

The arrangement of those blocks 47 to 51 will be explained below in more detail with reference to Fig. 5. The decoder comprises a deinterleaving section 46A, a code word dividing section 46B, random error correction decoding sections 47, burst error correction decoding sections 48, a synthesizing section 49, a CRC code checking section 50 and a maximum likelihood decoding selection section 51.

The random error correction decoding section 47 performs random error correction decoding with the use of the cyclic code. The random error correction decoding technique is not specifically restricted to the above, but here use is made of a Kasami's proposed technique entitled "A Decoding Procedure for Multiple-Error-Correcting Cyclic Codes" IEEE TRANSACTION ON INFORMATION THEORY, IT10, pp 134-139, April, 1964." This decoding technique is based on the hard decision of the receiver and, hence, requires a specific design concept when use is made of reliability information from a soft decision receiver. As the method for utilizing reliability information, Chase has proposed the technique entitled "A Class of Algorithms for Decoding Block Codes With Channel Measurement Information" IEEE TRANSACTIONS ON INFORMATION THEORY, VOL. LT-18, NO. 1, JANUARY 1972."

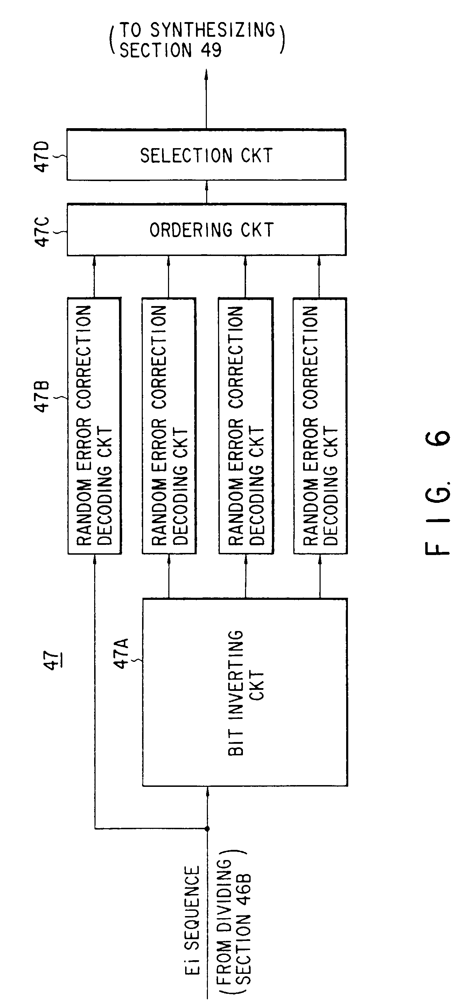

Fig. 6 shows a detailed block diagram of the random error correction decoding section 47 implemented by the Chase's technique. As shown in Fig. 6, the random error correction decoding section 47 comprises a bit inverting circuit 47A, a plurality of random error correction decoding circuits 47B, an ordering circuit 47C and a selection circuit 47C. First, a received word r (here an Ei sequence) is directly subjected by one random error correction decoding circuit 47B to a burst error correction decoding, while, on the other hand, those low reliability bits in the received word r are inverted by the bit inverting circuit 47A to generate those inverted code words r1, r2, .... These inverted codes are burst error correction decoded by the random error correction decoding circuit 47B. As the random error correction decoding circuit 47B use is made of, for example, Kasami's proposal. One decoding candidate is generated in this way and then the respective decoding candidates are ordered, by the ordering circuit 47C, in accordance with their reliability. Out of those decoding candidates ordered by the ordering circuit 47C, an i number of decoding candidates are selected by the selection circuit 47D in an increasing reliability order.

As the burst error correction decoding section 48 use is made of the cyclic code burst error correction technique as described in, for example, Miyakawa, Iwadare, Imai "Error Correction Coding" published by Shoko-Do in 1973. That is, out of 41 bits, those cyclically continuous 21 bits are selected and coded as information bits to generate redundancy bits. Even this burst error correction coding technique utilizes reliability information obtained from the soft-decision receiver.

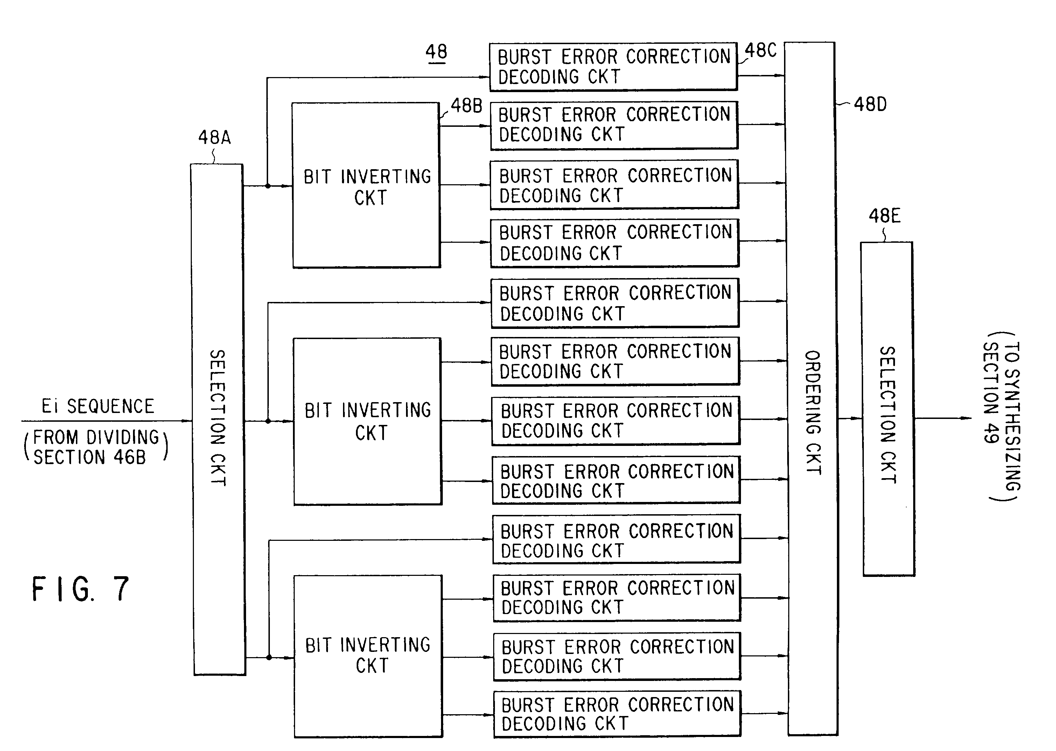

Fig. 7 is a detailed block diagram showing the burst error correction decoding section 48 utilizing the reliability information. The burst error correction decoding section 48 comprises a selection circuit 48A, a plurality of burst error correction decoding sections 48B, a plurality of burst error correction decoding circuits 48C, an ordering circuit 48D and a selection circuit 48E. First, the selection circuit 48 selects, out of those 41 bits in an A received word r, respective cyclically continuous 21 bits of high reliability. The selected 21 bits are referred to as seed bits. For the seed bits (selected 21 bits) those bits of relatively low reliability are inverted by the bit inverting circuits 48B to provide inverted seed bits. A J number of decoding candidates are generated by the burst error correction decoding (parity generation decoding) made by the burst error correction decoding circuits 48C with the use of the seed bits and inverted seed bits thus obtained. Then the J number of decoding candidates are individually ordered by the ordering circuit 48D in accordance with their reliability and, out of those ordered candidates, the J number of decoding candidates are selected by the selection circuit 48E in an increasing reliability order.

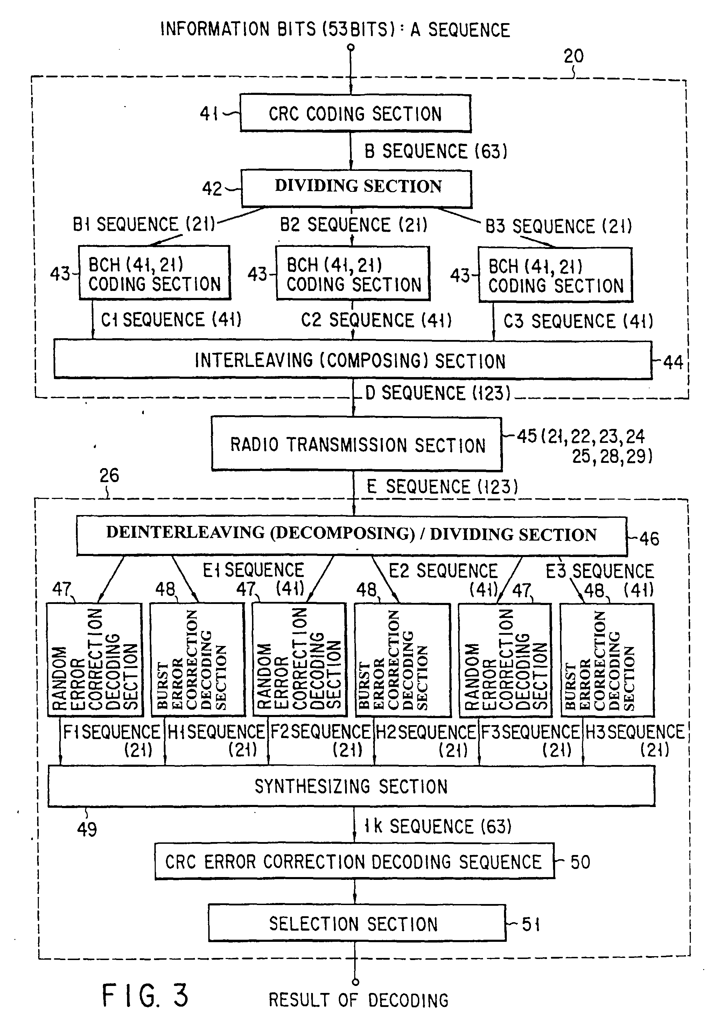

By the burst error correction decoding and random error correction decoding processings as shown in Figs. 6 and 7 an $(i + j)$ number of decoding candidates are generated for the respective Bi sequence. By so doing, an $(i + j)^3$ number of decoding candidates are obtained for the B sequence. In the CRC error detection decoding 50 as shown in Fig. 3 or Fig. 5, the error detection checking is made, by the CRC code, for all the $(i + j)^3$ decoding candidates. If a plurality of candidates are left as a result of checking, the highest reliability candidate is selected, as a decoding result (decoding word), from these candidates in the maximum likelihood decoding selection section 51.

As set out above, according to the first embodiment of the present invention, the burst and random error corrections are simultaneously made on the received sequence and error detection decoding processing is performed on a result of correction with the use of the CRC code. By so doing, it is possible to achieve efficient error correction even on the transmission path of the mobile radio system where there occurs a mixed random/burst error and to reduce the undetected error rate.

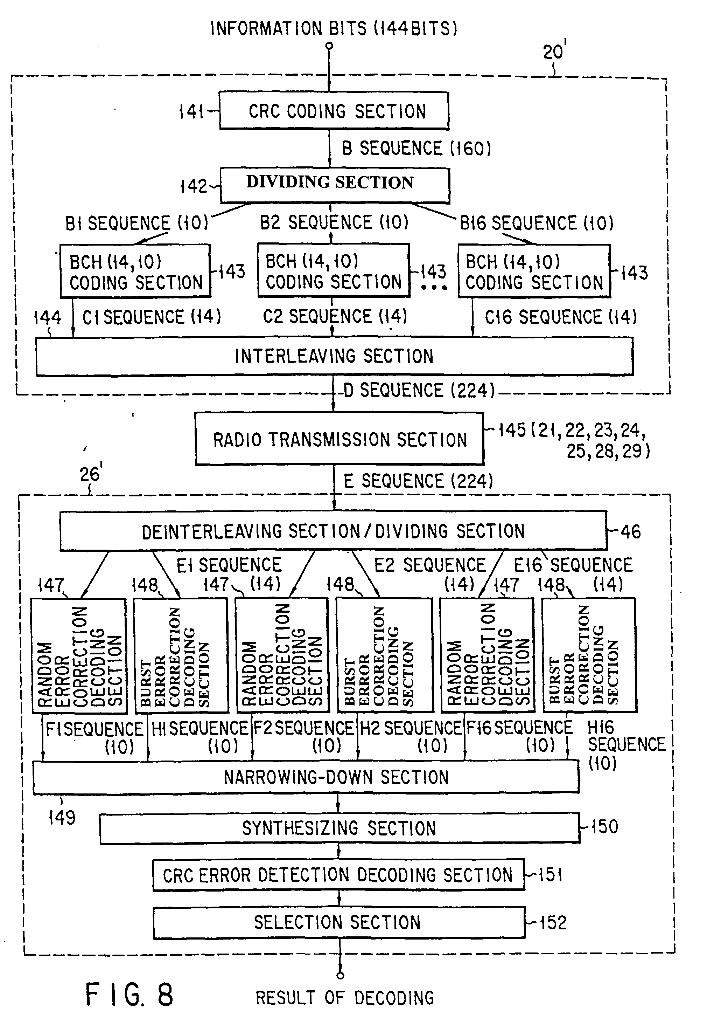

A system according to a second embodiment of the present invention will be explained below with reference to Figs. 8 and 9 to 11.

The system of the second embodiment as shown in Fig. 8 uses information bits (144 bits) as an A sequence. The second embodiment is substantially similar to the first embodiment as shown in Fig. 3 in terms of their block arrangement. That is, the second embodiment is the same as the first embodiment in terms of their CRC coding section (41 in Fig. 3 and 141 in Fig. 8), their dividing section (42 in Fig. 3 and 142 in Fig. 8), their BCH coding section (43 in Fig. 3 and 143 in Fig. 8), their interleaving section (44 in Fig. 3 and 144 in Fig. 8), their radio transmission section (45 in Fig. 3 and 145 in Fig. 8), their deinterleaving section/dividing section (46 in Fig. 3 and 146 in Fig. 8), their random error correction decoding section (47 in Fig. 3 and 147 in Fig. 8) and their burst error correction coding section (48 in Fig. 3 and 148 in Fig. 8). A coder 20' as shown in Fig. 8 is substantially the same as the coder 20 as shown in Fig. 3.

However, a decoder 26' as shown in Fig. 8 is different from the decoder 26 of Fig. 3 in the following respects. In the decoder 26', a narrowing-down section 149 is arranged between random error correction sections and burst error correction sections on one hand and a synthesizing section 150 on the other hand.

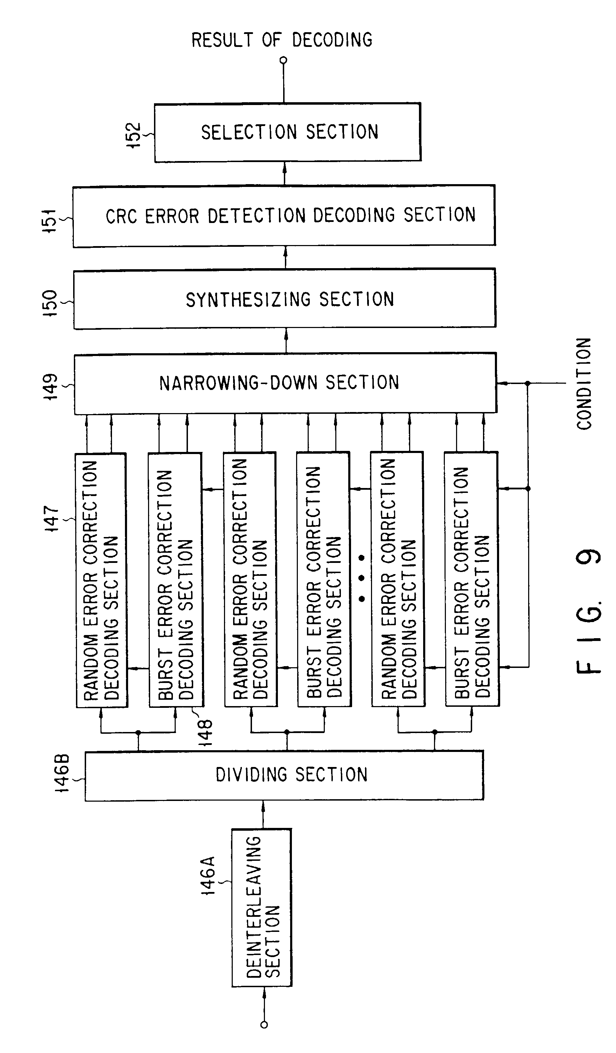

The narrowing-down section 149 is operated under the condition 1. That is, as shown in Fig. 9, prior to selecting a j3(i) number of decoding candidates out of an $(f(i) + j2(i))$ number of decoding candidates in the synthesizing section 149, an $f(i)$ number of $F_{i,f(i)}$ sequences are narrowed in number to an $f3(i)$ number $(f(i) \geqq f3(i))$ in order to reduce the number of candidates corresponding to the B sequence and a $j2(i)$ number of Hi sequences are narrowed in number to a $j3(i)$ number $(j2(i) \geqq j3(i))$.

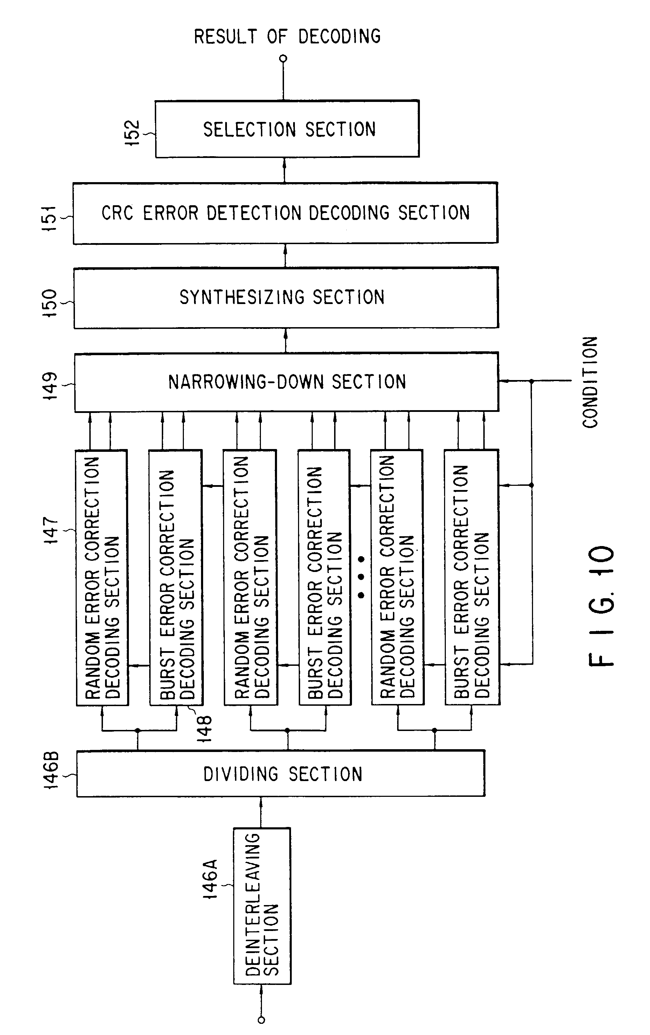

Further, the narrowing-down section 149 is operated under the condition 2. That is, as shown in Fig. 10, the decoder includes a means for obtaining the reliability of the $(f(i) + j2(i))$ number of decoding candidates and a means for, in order to reduce the candidates corresponding to the B sequence, narrowing the $f(i)$ number of $F_{i,f(i)}$ sequences and $j2(i)$ number of Hi sequences to a $f3(i)$ number $(f(i) \geqq f3(i))$ and $j3(i)$ number of Hi sequences $(j2(i) \geqq j3(i))$, respectively, in accordance with the level and relative level of the reliability obtained by the first-mentioned means.

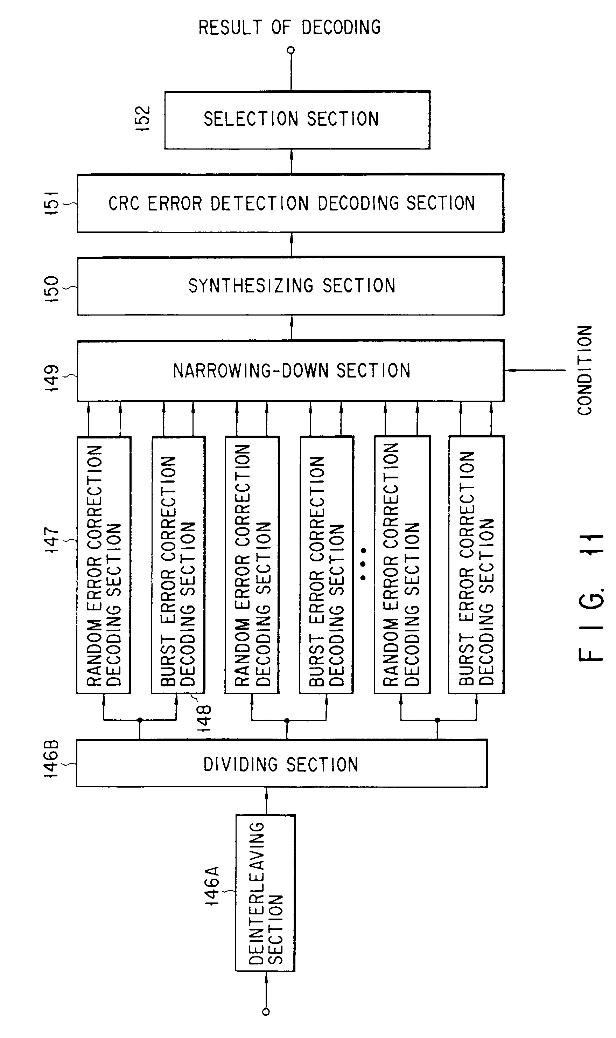

The narrowing-down section 149 is operated under the condition 3. That is, as shown in Fig. 11, in order to properly reduce the candidates corresponding to the B sequence to a predetermined number lower than the $\Pi i$ number $(f3(i) + j3(i))$, the $f(i)$ number of $F_{i,f(i)}$ sequences is narrowed to the $f3(i)$ number $(f(i) \geqq f3(i))$ and the $j2(i)$ number of the Hi sequences is narrowed to the $j3(i)$ number $(j2(i) \geqq j3(i))$.

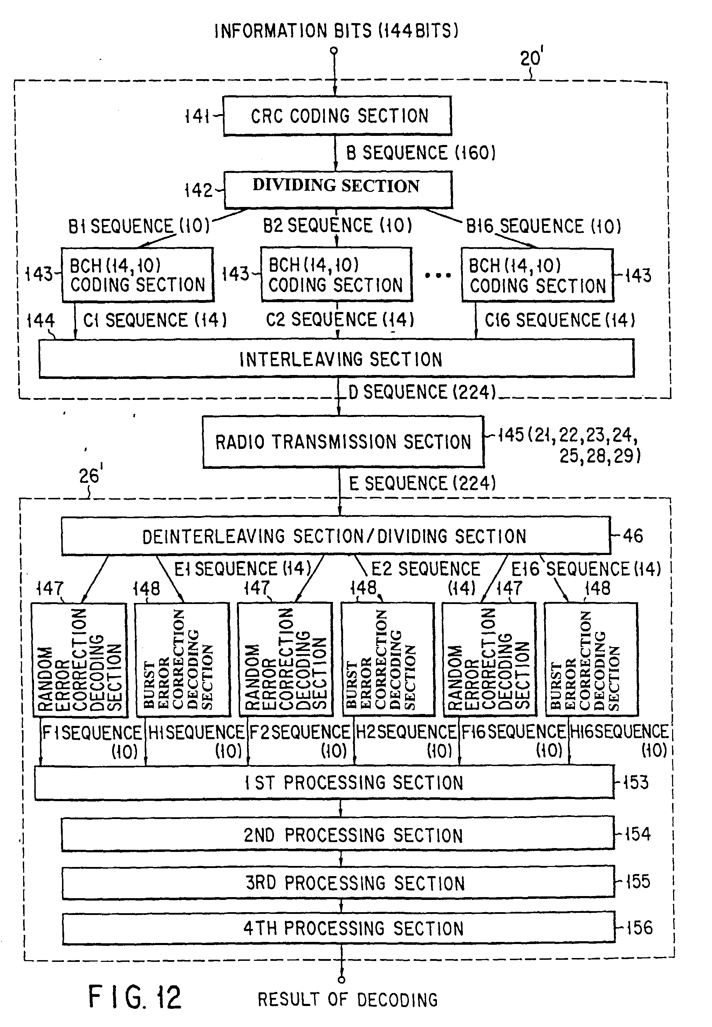

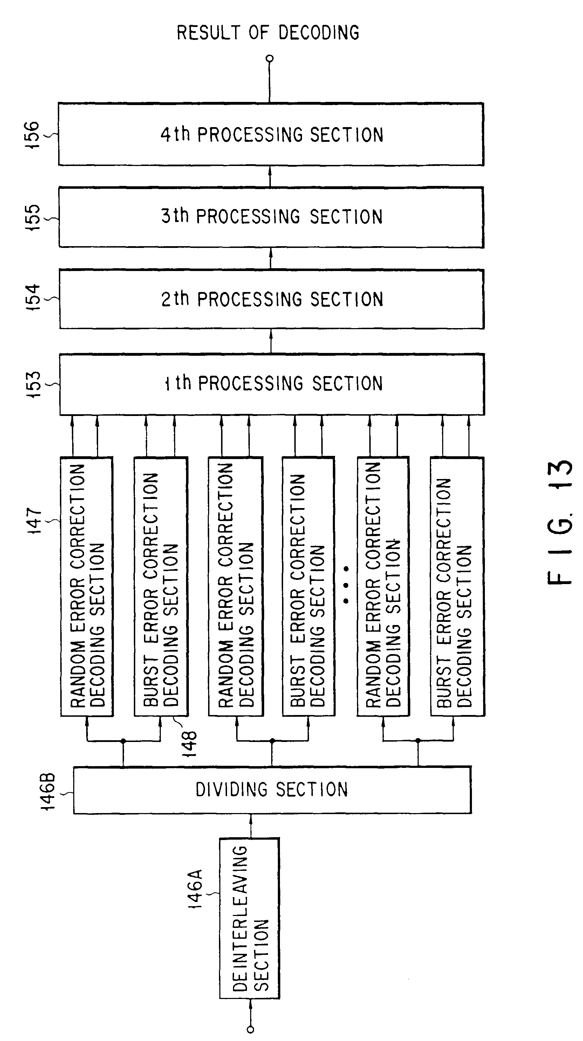

A system according to a third embodiment of the present invention will be explained below with reference to Figs. 12 and 13. In Figs. 12 and 13, the same reference numerals are employed to designate parts or elements corresponding to those shown in Fig. 8. That is, according to the third embodiment it is possible to reduce the number of decodings. In the aforementioned example, unless being specifically designed, an $\Pi iCWi$ number of CTC decodings are required because the presence of the $\Pi iCWi$ number of candidates. By the application of the processing as will be set out below, the number of the CRC decoding can be reduced to $(\Sigma i (CWi - 1) + 1)$ times, thus being capable of reducing an amount of processing. It is possible to reduce a delay time between the transmitting side and the receiving side. As shown in Figs. 12 and 13, a decoder includes first, second, third and fourth processing sections 153, 154, 155 and 156, respectively.

In the case where an $f4(i)$ $(i = 1$ to $k)$ number of candidates are given as those random error correction decoding candidates for Fi sequences generated by random error correction decoding sections and a $j4(i)$ $(i = 1$ to $k)$ number of candidates are given as those burst error correction decoding candidates for Hi sequences generated by burst error correction decoding sections, the first processing section 153 provides an IK0 sequence with the use of Fi $(i = 1$ to $16)$. The IK0 sequence performs CRC error correction decoding and those redundancy bits R0 in the decoding sequence are stored.

With those information bits all given as zeroes except for i-th information bits in the CRC error correction decoded sequence, the second processing section 154 provides the i-th information bits in the CRC error correction decoded sequence as an IK sequence through a bitwise exclusive logical sum of decoding candidates corresponding to a Ci sequence and an Fi sequence, subjects the IK sequence to CRC error correction decoding and stores a result as decoded redundancy bits Ri, $j(i)$ $(i = 1$ to $k$, $j(i) = 1$ to $(f4(i) + j4(i) = 1))$.

The third processing section 155 applies the following logical processing to all those decoding candidate combinations and decides that a result of the logical processing becomes a zero:

$$R0\,{}^{ER}R1, J(i)\,{}^{ER}R2, J(i)\,{}^{ER}R3, J(i) \dots {}^{ER}Rk, J(i)$$

provided that $^{ER}$ represents a bitwise exclusive logical sum.

In the case where R0 or a result of such logical processing is zero, the fourth processing section 156 decides that a result of the exclusive logical sum of Ik0 and Ik is an error-free final decoding result.

The first processing section 153, second processing section 154, third processing section 155 and fourth processing section 156 will be explained below in more detail.

In the case where an $f4(i)$ $(i = i$ to $k)$ number of coding candidates are present as random error correction coding candidates in the Fi sequence generated from the random error correction decoding sections and a $j4(i)$ $(i = 1$ to $k)$ number of decoding candidates are present as burst error correction decoding candidates in the Hi sequence generated from the burst error correction decoding sections 148, the first processing section 153 obtains second candidates Io corresponding to the B sequence through the combination of first candidates Ji (Fig. 1) corresponding to the Bi sequence $(i = 1$ to $k)$, obtains a syndrome So through the error detection decoding of the second candidates Io and stores the syndrome So.

The second processing section 154 operates as follows. To be specific, a sequence $Li,m$ $(i = 1$ to $k$, $m = 1$ to $(f4(i) + j(4(i))$ is generated as given below:

$$Li,m = Fi,1\,{}^{ER}Fi,m \ (m = 1 \text{ to } f4(i))$$

$$Li,m = Fi,1\,{}^{ER}Fi,(m-fr(i))(m = f4(i)+1 \text{ to } f4(i)+j4(i))$$

provided that $^{ER}$ shows a bitwise exclusive logical sum.

For a given $j$ $(i \leqq j \leqq k)$

$$Ji = Li,m \ (i = j)$$

$J_i$ = all zero bit sequence ($i \neq j$)
under which condition

$J_i$ ($i = 1$ to $k$) is generated. Through the combination of $J_i$ as shown in Fig. 15, an I' sequence is generated. Making the same processing as that on the second candidates Io gives a syndrome $S_{j,m}$. In this case, the syndrome $S_{j,m}$ is generated for each J ($J = 1$ to $k$) and each $m = 1$ to ($f4(i)+j4(i)$). Each syndrome $S_{j,m}$ is stored.

The third processing section 155 operates as follow:

That is, m1, m2, ..., mk are defined as given below:

$$1 \leqq m1 \leqq (f4(i)+j4(1))$$

$$1 \leqq m2 \leqq (f4(i)+j4(2))$$

$$1 \leqq mk \leqq (f4(i)+j4(k))$$

To all combinations ($\Pi$ ($f4(i)+j4(k)$) combinations) of m1, m2, ..., mk, the following logical processing is applied $So^{ER}Si$, $m1^{ER}S2$, $m2^{ER}S3$, $m3^{ER}Si$, $m1^{ER}$. As a result, it is determined that the sequence obtained is all zero bits.

The fourth processing section 156 operates as follows:

That is, when the sequence whose bits are all zeros at m1, m2, ... mk is obtained by the third processing section 155, $J_i$ ($i = k$) is generated by the following processing.

$$J1 = F1,1 {}^{ER}L1,m1$$

$$J2 = F2,1 {}^{ER}L2,m2$$

$$\cdot$$

$$\cdot$$

$$\cdot$$

$$Jk = Fk,1 {}^{ER}Lk,mk$$

An I" sequence is generated through combination of $J_i$ as shown in Fig. 15. The I" sequence is determined as a result of final decoding which contains no error for B.

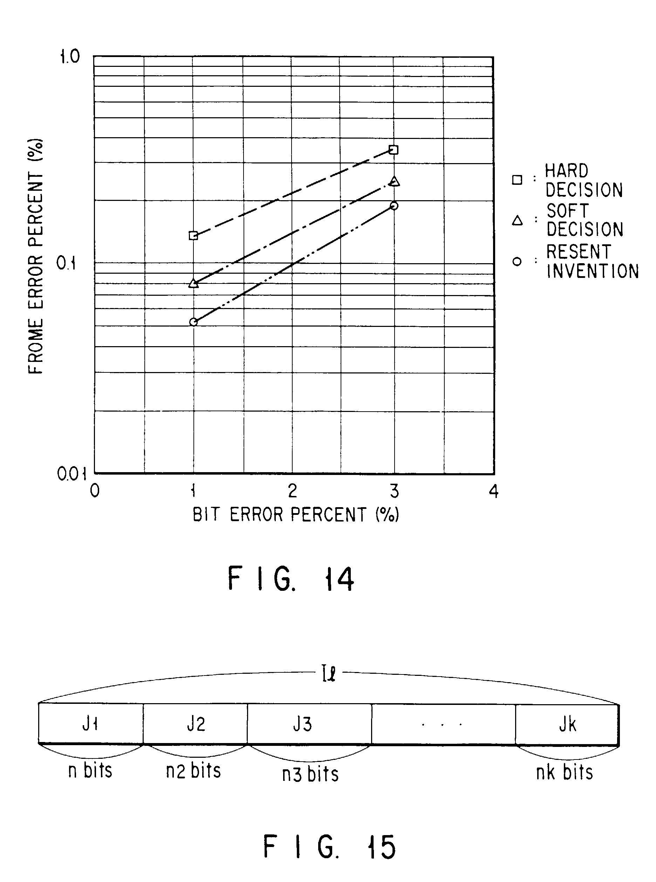

According to the present invention, as set out above, the advantage can be confirmed from Fig. 14. In Fig. 14, the abscissa represents a bit error rate and the ordinate a frame error rate. According to the present invention, the frame error rate can be reduced to about one half that rate compared with the conventional technique (soft decision, hard decision).

**Claims**

1. System for transmitting an information bit sequence comprising:

    a coder (20, 27) for error detection coding the information bit sequence, and error correction coding the error detection coded sequence;

    a transmission section (45, 145) for transmitting the error correction coded sequence; and

    a decoder (26, 30) for decoding the error correction coded sequence transmitted from the transmission section (45, 145),

    *characterized in that*

    the decoder (26, 30) includes means (47) for random error correction decoding the error correction coded sequence and means (48) for burst error correction decoding said error correction coded sequence, and error detection decoding the decoded sequence.

2. System according to claim 1, *characterized in that* the coder (20, 27) comprises:

    an error detection coding section (41, 141) for error detection coding the information bit sequence A, thereby generating a B sequence having information bits and redundancy bits;

    a dividing section (42, 142) for dividing the B sequence into k parts, thereby generating Bi (suffix $i = 1$ to $k$) sequences;

    k error correction coding units (43, 143) for error correction coding the Bi sequences, thereby generating Ci sequences; and

    an interleaving section (44, 144) for interleaving the Ci sequences, thereby generating a D sequence.

3. System according to claim 2, *characterized in that* the decoder (26, 30) comprises:

    a deinterleaving section (46, 146) for deinterleaving the D sequence transmitted from the transmission section (45, 145);

    a dividing section (46, 146) for dividing the deinterleaved sequence into k parts, thereby generating Ei sequences;

    k random error correction decoding units (47, 147) for random error correction decoding the Ei sequences, thereby generating Fi sequences;

k burst error correction decoding units (48, 148) for burst error correction decoding the Ei sequences, thereby generating Hi sequences; and

means (49, 50, 51, 149, 150, 151) for generating first decoded candidates j(i) corresponding to the Bi sequences by selecting a $(1 + j(i))$ number out of the Fi and $H_{i,1}$, $H_{i,2}$, $H_{i,j(i)}$ sequences, for generating second decoded candidates Ik (suffix k = 1 to K) corresponding to the Bi sequences by combining the first decoded candidates and for generating a decoded result of the information bit sequences corresponding to the A sequence by error detection decoding the second decoded candidates Ik.

4. System according to claim 1, *characterized in that* the decoder (26, 30) comprises:

a deinterleaving section (46, 146) for deinterleaving the D sequence transmitted from the transmission section (45, 145);

a dividing section (46, 146) for dividing the deinterleaved sequence into k parts, thereby generating Ei sequences;

k random error correction decoding units (47, 147) for random error correction decoding the Ei sequences, thereby generating Fi sequences;

k burst error correction decoding units (48, 148) for random error correction decoding the Ei sequences, thereby generating Hi sequences;

a first processing section (153) which, when an f4(i) number of decoded candidates are provided as those random error correction decoded candidates in the Fi sequences generated by the random error correction decoding unit and a j4(i) number of decoded candidates are provided as those burst error correction decoded candidates in the Hi sequences generated by the burst error correction decoding unit (147), provides an IK0 sequence with the use of the Fi sequences, error detection decodes the IK0 sequence and stores redundancy bits RO in the decoded sequence;

a second processing section (154) which provides the i-th information bits in the error detection decoded sequence as an IK sequence through a bitwise exclusive logical sum of decoded candidates corresponding to the Ci sequences and the Fi sequences with those information bits all given as zeroes except for i-th information bits in the error detection decoded sequence, error detection decodes the IK sequence and stores a result as a decoding redundancy bit $R_{i,J(i)}$;

a third processing section (155) for applying the following logical processing to all the decoded candidate combinations and deciding that a result of the logical processing becomes a zero:

$$R0 \,{}^{ER}R_{1,j(i)} \,{}^{ER}R_{2,j(i)} \,{}^{ER}R_{3,j(i)} \cdots {}^{ER}R_{k,j(i)}$$

provided that ER represents a bitwise exclusive logical sum; and

a fourth processing section (156) which, when R0 or a result of such logical processing is zero, decides that a result of the exclusive or of Ik0 and Ik is an error-free final decoded result.

5. System according to claim 1, *characterized in that* the transmission section (45, 145) includes a radio transmission section (21, 22, 23, 24, 25, 45, 145) for a mobile radio system.

6. System according to claim 3 or 4, *characterized in that* the random error correction decoding unit (47, 147) includes means for generating a j2(i) number of the Hi sequences by inverting, out of the Di sequences, those bits of relatively low reliability and applying a generation polynomial of the cyclic code to an ni bit sequence comprising non-bit-inverted information bits and bit-inverted information bits in the Di sequences.

7. System according to claim 3 or 4, *characterized in that* the burst error correction decoding unit (48, 148) comprises means for generating Hi sequences corresponding to the Ei sequences by repeating, in a sequential bit position displacing fashion, the processing for selecting the ni number of cyclically continuous information bits out of the respective Ei sequences, processing for generating the E1i sequences by applying the generation polynomial of the cyclic code to the information bits and processing for generating the E2i sequences of ni bits corresponding to the Bi sequences by cyclically shifting the E1i sequences, wherein

$$H1 = H_{1,1}, H_{1,2}, ..., H_{1,j(1)}$$

$$H2 = H_{2,1}, H_{2,2}, ..., H_{2,j(2)}$$

$$H3 = H_{3,1}, H_{3,2}, ..., H_{3,j(3)}$$

........          .....

$$Hk = H_{k,1}, H_{k,2}, ..., H_{k,j(k)}.$$

8. System according to claim 3 or 4, *characterized in that* the burst error correction decoding unit (48, 148) includes means for generating a j2(i) number of the Hi sequences, by a generation polynomial of the cyclic code, from cyclically continuous ni (index n) bits in the Ei sequences and an ni bit sequence obtained from those inverted bits of relatively low reliability in the Ei sequences.

9. System according to claim 3 or 4, *characterized in that:*

the means (49, 50, 51, 149, 150, 151) comprises a synthesizing section (49, 149), an error detection decoding section (50, 150) and a maximum likelihood selection section (51, 151);

the synthesizing section (49, 149) and maximum likelihood selection section (51, 151) generate first decoded candidates corresponding to the Bi sequence by selecting out of the Fi and $H_{i,1}$, $H_{i,2}$, ..., $H_{i,j(i)}$ sequences, and generate second decoded candidates Ik corresponding to the B sequence by combining together the first decoded candidates; and

the k error detection decoding units (47, 147) generate a decoded result of an information bit sequence corresponding to the A sequence by performing error detection decoding of the second decoded candidates Ik.

10. System according to claim 3, 4 or 9, *characterized in that:*

the k random error correction decoding units (47, 147) include means for generating an f(i) number of the Fi sequences as decoded candidates corresponding to the Ei sequences by a soft decision decoding using reliability information obtained at a receiving side;

the k burst error correction decoding units (48, 148) include means for generating a j2(i) number of the Hi sequences, by a generation polynomial of the cyclic code, from cyclically continuous ni bits in the Ei sequences and an ni bit sequence obtained from those inverted bits of relatively low reliability in the Ei sequences;

the synthesizing section (49, 149) includes means for generating an (f(i) + j2(i)) number of decoded candidates as those decoded candidates corresponding to the Ei sequences and generating decoded candidates Ik corresponding to the B sequence by selecting a j3(i) number of decoded candidates out of the (f(i) + j2(i)) number of decoded candidates in an increasing reliability order; and

the error detection decoding section (50, 150) and maximum likelihood selection section (51, 151) include means which, when, upon the error detection decoding of the decoded candidates, only one decoded candidate is found as containing no error, selects its decoded candidate as a decoded result of the information bit sequence and, when a plurality of decoded candidates are found as containing no error, selects a highest reliability decoded candidate out of these decoded candidates, as the decoded result of the information bit sequence in the A sequence, by comparing the decoded candidates for reliability.

11. System according to claim 3 or 4, *characterized in that* it further comprises a narrowing-down section (149) provided between the random error correction decoding unit (147) and burst error correction decoding unit (148) on one hand and the synthesizing section (150) on the other hand, the narrowing-down section (149) being of such a type that, in order to suppress those candidates corresponding to the B sequence to T1i (f3(i) + j3(i)) prior to selecting a j3(i) number of decoded candidates out of an (f(i) + j2(i)) number of decoded candidates in an increasing reliability order in the synthesizing section, the narrowing-down section narrows the f(i) number of Fi sequences down to f3(i) number (f(i) ≥ f3(i)) and the j2(i) number of Hi sequences down to j3(i) (j2(i) ≥ j3(i)).

12. System according to claim 11, *characterized in that* the narrowing-down section (149) includes means for obtaining the reliability of the (f(i) + j2(i)) number of decoded candidates and means for, in order to suppress the candidates corresponding to the B sequence to Πi(f3(i) + j3(i)), narrowing the f(i) number of the Fi sequences to f3(i) (f(i) ≥ f3(i)) and the j2(i) number of the Hi sequences to j3(i) (j2(i) ≥ j3(i)) in accordance with the level and relative level of the reliability obtained by the reliability obtaining means.

13. System according to claim 3 or 4, *characterized in that* it further comprises a narrowing-down section (149) provided between the random error correction decoding unit (147) and burst error correction decoding unit (148) on the one hand and the synthesizing section (150) on the other hand, the narrowing-down section being of such a type that, in order to suppress the candidates corresponding to a predetermined number lower than $\Pi i$ (f3(i) + j3(i)) prior to selecting a j3(i) number of decoded candidates out of an (f(i) + j2(i)) number of decoded candidates in the synthesizing section in an increasing reliability order, the narrowing-down section narrows the f(i) number of the Fi sequences to f3(i) (f(i) $\geq$ f3(i)) and the j2(i) number of the Hi sequences to j3(i) (j2(i) $\geq$ j3(i)).

14. System according to claim 13, *characterized in that* the narrowing-down section (149) includes means for obtaining the reliability of the (f(i) + j2(i)) number of the decoded candidates and means for, in order to suppress the number of the candidates corresponding to the B sequence to $\Pi i$ (f3(i) + j3(i)), narrowing the f(i) number of the Fi sequences to f3(i) (f(i) $\geq$ f3(i)) and the j2(i) number of the Hi sequences to j3(i) (j2(i) $\geq$ j3(i)) in accordance with the level and relative level of the reliability obtained by the reliability obtaining means.

15. System according to claim 1, *characterized in that* said random error correction decoding means (47) and said burst error correction decoding means (48) respectively output plural decoded candidates and said decoder (26, 30) further comprises a selector (51) for selecting one of said plural decoded candidates.

16. System according to one of claims 1 to 15, *characterized in that* said coder (20, 27) comprises a CRC error detection coder (41) and a BCH error detection coder (43).

**Patentansprüche**

1. System zum Übertragen einer Informationsbitsequenz, das aufweist:

   einen Codierer (20, 27) zum Fehlererfassungscodieren der Informationsbitsequenz und Fehlerkorrekturcodieren der fehlererfassungscodierten Sequenz;

   einen Übertragungsbereich (45, 145) zum Übertragen der fehlerkorrekturcodierten Sequenz; und

   einen Decodierer (26, 30) zum Decodieren der fehlerkorrekturcodierten Sequenz, die von dem Übertragungsbereich (45, 145) übertragen wird,

*dadurch gekennzeichnet, daß*

   der Decodierer (26, 30) eine Einrichtung (47) zum Zufallsfehlerkorrekturdecodieren der fehlerkorrekturcodierten Sequenz und eine Einrichtung (48) zum Büschelfehlerkorrekturdecodieren der fehlerkorrekturcodierten Sequenz beinhaltet, und die decodierte Sequenz fehlererfassungsdecodiert.

2. System nach Anspruch 1, *dadurch gekennzeichnet, daß* der Codierer (20, 27) aufweist:

   einen Fehlererfassungscodierbereich (41, 141) zum Fehlererfassungscodieren der Informationsbitsequenz A, um dadurch eine B-Sequenz zu erzeugen, die Informationsbits und Redundanzbits aufweist;

   einen Teilerbereich (42, 142) zum Teilen der B-Sequenz in k Teile, um dadurch Bi-(Zusatz i = 1 bis k)-Sequenzen zu erzeugen;

   k Fehlerkorrekturcodiereinheiten (43, 143) zum Fehlerkorrekturcodieren der Bi-Sequenzen, um dadurch Ci-Sequenzen zu erzeugen; und

   einen Verschachtelungsbereich (44, 144) zum Verschachteln der Ci-Sequenzen, um dadurch eine D-Sequenz zu erzeugen.

3. System nach Anspruch 2, *dadurch gekennzeichnet, daß* der Decodierer (26, 30) aufweist:

   einen Entschachtelungsbereich (46, 146) zum Entschachteln der D-Sequenz, die von dem Übertragungsbereich (45, 145) übertragen wird;

   einen Teilerbereich (46, 146) zum Teilen der entschachtelten Sequenz in k Teile, um dadurch Ei-Sequenzen zu erzeugen;

   k Zufallsfehlerkorrekturdecodiereinheiten (47, 147) zum Zufallsfehlerkorrekturdecodieren der Ei-Sequenzen, um dadurch Fi-Sequenzen zu erzeugen;

   k Büschelfehlerkorrekturdecodiereinheiten (48, 148) zum Büschelfehlerkorrekturdecodieren der Ei-Sequenzen, um dadurch Hi-Sequenzen zu erzeugen; und

   eine Einrichtung (49, 50, 51, 149, 150, 151) zum Erzeugen erster decodierter Kandidaten J(i), die den Bi-Sequenzen entsprechen, durch Auswählen einer (1 + j(i)) Anzahl aus den Fi- und den $H_{i,1}$-, $H_{i,2}$-, $H_{i,j(i)}$-Sequenzen, zum Erzeugen zweiter decodierter Kandidaten Ik (Zusatz k = 1 bis K), die den Bi-Sequenzen entsprechen, durch Kombinieren der ersten codierten Kandidaten, und

zum Erzeugen eines Decodierungsergebnisses der Informationsbitsequenzen, das der A-Sequenz entspricht, durch Fehlererfassungsdecodieren der zweiten decodierten Kandidaten Ik.

4. System nach Anspruch 1, *dadurch gekennzeichnet, daß* der Decodierer (26, 30) aufweist:

einen Entschachtelungsbereich (46, 146) zum Entschachteln der D-Sequenz, die von dem Übertragungsbereich (45, 145) übertragen wird;

einen Teilerbereich (46, 146) zum Teilen der entschachtelten Sequenz in k Teile, um dadurch Ei-Sequenzen zu erzeugen;

k Zufallsfehlerkorrekturdecodiereinheiten (47, 147) zum Zufallsfehlerkorrekturdecodieren der Ei-Sequenzen, um dadurch Fi-Sequenzen zu erzeugen;

k Büschelfehlerkorrekturdecodiereinheiten (48, 148) zum Büschelfehlerkorrekturdecodieren der Ei-Sequenzen, um dadurch Hi-Sequenzen zu erzeugen;

einen ersten Verarbeitungsbereich (153), welcher, wenn ein f4(i) Anzahl von decodierten Kandidaten als diese zufallsfehlerkorrekturcodierten Kandidaten in den Fi-Sequenzen geliefert werden, die von der Zufallsfehlerkorrekturdecodiereinheit erzeugt werden, und eine j4 (i) Anzahl von decodierten Kandidaten als diese büschelfehlerkorrekturdecodierten Kandidaten in den Hi-Sequenzen geliefert werden, die von der Büschelfehlerkorrekturdecodiereinheit (147) erzeugt werden, eine IK0-Sequenz unter Verwendung der Fi-Sequenzen liefert, die IK0-Sequenz fehlererfassungsdecodiert und Redundanzbits R0 in der decodierten Sequenz speichert;

einen zweiten Verarbeitungsbereich (154), welcher die i-ten Informationsbits in der fehlererfassungsdecodierten Sequenz als eine IK-Sequenz durch eine bitweise exklusive logische Summe von decodierten Kandidaten liefert, die den Ci-Sequenzen und den Fi-Sequenzen entsprechen, wobei diese Informationsbits ausgenommen von i-ten Informationsbits in der fehlererfassungsdecodierten Sequenz alle als Nullen gegeben sind, die IK-Sequenz fehlererfassungsdecodiert und ein Ergebnis als ein Decodierungsredundanzbit $R_{i,J(i)}$ speichert;

einen dritten Verarbeitungsbereich (155) zum Anwenden der folgenden logischen Verarbeitung an allen Kombinationen der decodierten Kandidaten und Entscheiden, daß ein Ergebnis der logischen Verarbeitung eine Null wird:

$$R0^{ER}R_{1,j(i)}{}^{ER}R_{2,j(i)}{}^{ER}R_{3,j(i)} \cdots {}^{ER}R_{k,j(i)}$$

unter der Annahme, daß ER eine bitweise exklusive logische Summe darstellt; und

einen vierten Verarbeitungsbereich (156), welcher, wenn R0 oder ein Ergebnis einer derartigen logischen Verarbeitung null ist, entscheidet, daß ein Ergebnis des Exklusiven oder von Ik0 und Ik ein fehlerfreies endgültiges Decodierungsergebnis ist.

5. System nach Anspruch 1, *dadurch gekennzeichnet, daß* der Übertragungsbereich (45, 145) einen Funkübertragungsbereich (21, 22, 23, 24, 25, 45, 145) für ein Mobilfunksystem beinhaltet.

6. System nach Anspruch 3 oder 4, *dadurch gekennzeichnet, daß* die Zufallsfehlerkorrekturdecodiereinheit (47, 147) eine Einrichtung zum Erzeugen einer j2(i) Anzahl der Hi-Sequenzen durch Invertieren derartiger Bits einer relativ niedrigen Zuverlässigkeit aus den Di-Sequenzen und Anwenden eines Generatorpolynoms des zyklischen Codes an einer ni-Bit-Sequenz aufweist, die nichtbitinvertierte Informationsbits und bitinvertierte Informationsbits in den Di-Sequenzen aufweist.

7. System nach Anspruch 3 oder 4, *dadurch gekennzeichnet, daß* die Büschelfehlerkorrekturdecodiereinheit (48, 148) eine Einrichtung zum Erzeugen von Hi-Sequenzen, die den Ei-Sequenzen entsprechen, durch Wiederholen der Verarbeitung zum Auswählen der ni Anzahl von zyklisch zusammenhängenden Informationsbits aus den jeweiligen Ei-Sequenzen, Verarbeitung zum Erzeugen der E1i-Sequenzen durch Anwenden des Generatorpolynoms des zyklischen Codes an den Informationsbits und Verarbeitung zum Erzeugen der E2i-Sequenzen von ni Bits, die den Bi-Sequenzen entsprechen, durch zyklisches Verschieben der E1i-Sequenzen auf eine aufeinanderfolgend bitstellenverschiebene Weise aufweist, wobei

$$H1 = H_{1,1}, H_{1,2}, ..., H_{1,j(1)}$$

$$H2 = H_{2,1}, H_{2,2}, ..., H_{2,j(2)}$$

$$H3 = H_{3,1}, H_{3,2}, ..., H_{3,j(3)}$$

$$........ \qquad .....$$

$$Hk = H_{k,1}, H_{k,2}, ..., H_{k,j(k)}.$$

8. System nach Anspruch 3 oder 4, *dadurch gekennzeichnet, daß* die Büschelfehlerkorrekturdecodiereinheit (48, 148) eine Einrichtung zum Erzeugen einer $j2(i)$ Anzahl der Hi-Sequenzen durch ein Generatorpolynom des zyklischen Codes aus zyklisch zusammenhängenden $ni$ (Index $n$) Bits in den Ei-Sequenzen und einer $ni$-Bit-Sequenz aufweist, die aus diesen invertierten Bits von relativ niedriger Zuverlässigkeit in den Ei-Sequenzen erzielt wird.

9. System nach Anspruch 3 oder 4, *dadurch gekennzeichnet, daß:*

   die Einrichtung (49, 50, 51, 149, 150, 151) einen Synthetisierbereich (49, 149), einen Fehlererfassungsdecodierbereich (50, 150) und einen Maximalwahrscheinlichkeits-Auswahlbereich (51, 151) aufweist;

   der Synthetisierbereich (49, 149) und Maximalwahrscheinlichkeits-Auswahlbereich (51, 151) erste decodierte Kandidaten, die den Bi-Sequenzen entsprechen, durch Auswählen aus den Fi- und $H_{i,1}$-, $H_{i,2}$-, ..., $H_{i,j(i)}$- Sequenzen erzeugen und zweite decodierte Kandidaten Ik, die der B-Sequenz entsprechen, durch Zusammenkombinieren mit den ersten decodierten Kandidaten erzeugen; und

   die $k$ Fehlererfassungsdecodiereinheiten (47, 147) ein Decodierungsergebnis einer Informationsbitsequenz, die der A-Sequenz entspricht, durch Durchführen eines Fehlererfassungsdecodierens der zweiten decodierten Kandidaten Ik erzeugen.

10. System nach Anspruch 3, 4 oder 9, *dadurch gekennzeichnet, daß:*

    die $k$ Zufallsfehlerkorrekturdecodiereinheiten (47, 147) eine Einrichtung zum Erzeugen einer $f(i)$ Anzahl der Fi-Sequenzen als decodierte Kandidaten, die den Ei-Sequenzen entsprechen, durch ein Weichentscheidungsdecodieren, das eine an einer Empfängerseite erzielte Zuverlässigkeitsinformation verwendet, beinhaltet;

    die $k$ Büschelfehlerkorrekturdecodiereinheiten (48, 148) eine Einrichtung zum Erzeugen einer $j2(i)$ Anzahl der Hi-Sequenzen durch ein Generatorpolynom der zyklischen Codes aus zyklisch zusammenhängenden $ni$ Bits in den Ei-Sequenzen und einer $ni$-Bit-Sequenz beinhalten, die aus diesen invertierten Bits einer relativ niedrigen Zuverlässigkeit in den Ei-Sequenzen erzielt wird;

der Synthetisierbereich (49, 149) eine Einrichtung zum Erzeugen einer $(f(i) + j2(i))$ Anzahl von decodierten Kandidaten als diese decodierten Kandidaten, die den Ei-Sequenzen entsprechen, und Erzeugen decodierter Kandidaten Ik, die der B-Sequenz entsprechen, durch Auswählen einer $j3(i)$ Anzahl von decodierten Kandidaten aus der $(f(i) + j2(i))$ Anzahl von decodierten Kandidaten in einer Reihenfolge einer sich erhöhenden Zuverlässigkeit beinhaltet; und

der Fehlererfassungsdecodierbereich (50, 150) und Maximalwahrscheinlichkeits-Auswahlbereich (51, 151) eine Einrichtung beinhalten, welche, wenn nach dem Fehlererfassungsdecodieren der decodierten Kandidaten lediglich ein decodierter Kandidat als keinen Fehler enthaltend festgestellt wird, ihren decodierten Kandidaten als ein Decodierungsergebnis der Informationsbitsequenz auswählt, und, wenn eine Mehrzahl von decodierten Kandidaten als keinen Fehler enthaltend festgestellt wird, einen decodierten Kandidaten höchster Zuverlässigkeit aus diesen decodierten Kandidaten als ein Decodierungsergebnis der Informationsbitsequenz in der A-Sequenz durch Vergleichen der decodierten Kandidaten hinsichtlich einer Zuverlässigkeit auswählt.

11. System nach Anspruch 3 oder 4, *dadurch gekennzeichnet, daß* es weiterhin einen Verschmälerungsbereich (149) aufweist, der zwischen einerseits der Zufallsfehlerkorrekturdecodiereinheit (147) und Büschelfehlerkorrekturdecodiereinheit (148) und andererseits dem Synthetisierbereich (150) vorgesehen ist, wobei der Verschälerungsbereich (149) von einem derartigen Typ ist, daß, um derartige Kandidaten, die der B-Sequenz entsprechen, vor einem Auswählen einer $j3(i)$ Anzahl von decodierten Kandidaten aus einer $(f(i) + j2(i))$ Anzahl von decodierten Kandidaten in einer Reihenfolge einer sich erhöhenden Zuverlässigkeit in dem Synthetisierbereich auf $T1i$ $(f3(i) + j3(i))$ zu senken, der Verschmälerungsbereich die $f(i)$ Anzahl von Fi-Sequenzen auf eine $f3(i)$ Anzahl $(f(i) \geq f3(i))$ und die $j2(i)$ Anzahl von Hi-Sequenzen auf $j3(i)$ $(j2(i) \geq j3(i))$ verschmälert.

**12.** System nach Anspruch 11, *dadurch gekennzeichnet, daß* der Verschmälerungsbereich (149) eine Einrichtung zum Erzielen der Zuverlässigkeit der (f (i) + j2(i)) Anzahl von decodierten Kandidaten und eine Einrichtung zum Verschmälern der f(i) Anzahl der Fi-Sequenzen auf f3(i) (f(i) ≥ f3(i)) und der j2(i) Anzahl der Hi-Sequenzen auf j3(i) (j2(i) ≥ j3(i)) in Übereinstimmung mit dem Pegel und relativen Pegel der Zuverlässigkeit beinhaltet, die durch die Zuverlässigkeitserzielungseinrichtung erzielt werden, um die Kandidaten, die der B-Sequenz entsprechen, auf Πi(f3(1) + j3(i)) zu senken.

**13.** System nach Anspruch 3 und 4, *dadurch gekennzeichnet, daß* es weiterhin einen Verschmälerungsbereich (149) aufweist, der zwischen einerseits der Zufallsfehlerkorrekturdecodiereinheit (147) und Büschelfehlerkorrekturdecodiereinheit (148) und andererseits dem Synthetisierbereich (150) vorgesehen ist, wobei der Verschmälerungsbereich von einem derartigen Typ ist, daß, um die Kandidaten, die einer vorbestimmten Anzahl entsprechen, die niedriger als Πi (f3(i) + j3(i)) ist, vor einem Auswählen einer j3(i) Anzahl von decodierten Kandidaten aus einer (f(i) + j2(i)) Anzahl von decodierten Kandidaten in dem Synthetisierbereich in einer Reihenfolge einer sich erhöhenden Zuverlässigkeit zu senken, der Verschmälerungsbereich die f(i) Anzahl der Fi-Sequenzen auf f3(i) (f(i) ≥ f3(i)) und die j2(i) Anzahl der Hi-Sequenzen auf j3(i) (j2(i) ≥ j3(i)) verschmälert.

**14.** System nach Anspruch 13, *dadurch gekennzeichnet, daß* der Verschmälerungsbereich (149) eine Einrichtung zum Erzielen der Zuverlässigkeit der (f (i) + j2(i)) Anzahl der decodierten Kandidaten und eine Einrichtung zum Verschmälern der f(i) Anzahl der Fi-Sequenzen auf f3(i) (f(i) ≥ f3(i)) und der j2(i) Anzahl der Hi-Sequenzen auf j3(i) (j2(i) ≥ j3(i)) in Übereinstimmung mit dem Pegel und relativen Pegel der Zuverlässigkeit beinhaltet, die von der Zuverlässigkeitserzielungseinrichtung erzielt werden, um die Anzahl der Kandidaten, die der B-Sequenz entsprechen, auf Πi (f3(i) + j3(i)) zu senken.

**15.** System nach Anspruch 1, *dadurch gekennzeichnet, daß* die Zufallsfehlerkorrekturdecodiereinrichtung (47) und die Büschelfehlerkorrekturdecodiereinrichtung (48) jeweils mehrere decodierte Kandidaten ausgeben und der Decodierer (26, 30) weiterhin eine Auswahleinrichtung (51) zum Auswählen von einem der mehreren decodierten Kandidaten aufweist.

**16.** System nach einem der Ansprüche 1 bis 15, *dadurch gekennzeichnet, daß* der Codierer (20, 27) einen CRC-Fehlererfassungscodierer (41) und einen BCH-Fehlererfassungscodierer (43) aufweist.

**Revendications**

**1.** Système pour transmettre une séquence de bits d'information comprenant:

un codeur (20, 27) pour un codage par code détecteur d'erreur de la séquence de bits d'information, et un codage par code correcteur d'erreur de la séquence codée par code détecteur d'erreur;

une partie de transmission (45, 145) pour transmettre la séquence codée par code correcteur d'erreur; et

un décodeur (26, 30) pour décoder la séquence codée par code correcteur d'erreur transmise par la partie de transmission (45, 145),

caractérisé en ce que

le décodeur (26, 30) inclut un moyen (47) pour décoder avec correction d'erreur aléatoire la séquence codée par code correcteur d'erreur et un moyen (48) pour décoder avec correction d'erreur de salve ladite séquence codée par code correcteur d'erreur, et décoder le code détecteur d'erreur de la séquence décodée.

**2.** Système selon la revendication 1, caractérisé en ce que le codeur (20, 27) comprend:

une partie de codage par code détecteur d'erreur (41, 141) pour coder par code détecteur d'erreur la séquence de bits d'information A, générant ainsi une séquence B ayant des bits d'information et des bits redondants;

une partie de division (42, 142) pour diviser la séquence B en k parties, générant ainsi des séquences Bi (suffixe i= 1 à k);

k unités de codage par code correcteur d'erreur (43, 143) pour coder par code correcteur d'erreur les séquences Bi, générant ainsi des séquences Ci; et

une partie de multiplexage numérique (44, 144) pour multiplexer les séquences Ci, générant ainsi une séquence D.

**3.** Système selon la revendication 2, caractérisé en ce que le décodeur (26, 30) comprend:

une partie de démultiplexage numérique (46, 146) pour démultiplexer la séquence D transmise depuis la partie de transmission (45, 145);

une partie division (46, 146) pour diviser la séquence démultiplexée en k parties, générant ainsi des séquences Ei;

k unités de décodage avec correction d'erreur aléatoire (47, 147) pour décoder avec correction d'erreur aléatoire les séquences Ei, générant ainsi des séquences Fi;

k unités de décodage avec correction d'erreur de salve (48, 148) pour décoder avec correction d'erreur de salve les séquences Ei, générant ainsi des séquences Hi; et

un moyen (49, 50, 51, 149, 150, 151) pour générer des premiers candidats décodés j(i) correspondant aux séquences Bi en sélectionnant un nombre (1+j(i)) parmi les séquences Fi et $H_{i,1}$, $H_{i,2}$, $H_{i,j(i)}$, pour générer des second candidats décodés Ik (suffixe k= 1 à K) correspondant aux séquences Bi en combinant les premiers candidats décodés et pour générer un résultat décodé des séquences de bits d'information correspondant à la séquence A par décodage du code détecteur d'erreur des second candidats décodés Ik.

4. Système selon la revendication 1, caractérisé en ce que le décodeur (26, 30) comprend:

une partie de démultiplexage numérique (46, 146) pour démultiplexer la séquence D transmise depuis la partie de transmission (45, 145);

une partie division (46, 146) pour diviser la séquence démultiplexée en k parties, générant ainsi des séquences Ei;

k unités de décodage avec correction d'erreur aléatoire (47, 147) pour décoder avec correction d'erreur aléatoire les séquences Ei, générant ainsi des séquences Fi;

k unités de décodage avec correction d'erreur de salve (48, 148) pour décoder avec correction d'erreur de salve les séquences Ei, générant ainsi des séquences Hi;

une première partie de traitement (153) qui, lorsqu'un nombre f4(i) de candidats décodés sont fournis en tant que candidats décodés avec correction d'erreur aléatoire dans les séquences Fi générées par l'unité de décodage avec correction d'erreur aléatoire et qu'un nombre J4(i) de candidats décodés sont fournis en tant que candidats décodés avec correction d'erreur de salve dans les séquences Hi générées par l'unité de décodage avec correction d'erreur de salve (148), fournit une séquence IK0 avec l'utilisation des séquences Fi, décode le code détecteur d'erreur de la séquence IK0 et mémorise les bits redondants RO dans la séquence décodée;

une deuxième partie de traitement (154), qui fournit les $i^{ièmes}$ bits d'information dans la séquence décodée du code détecteur d'erreur sous la forme d'une séquence IK par une somme logique exclusive bit-à-bit des candidats décodés correspondant aux séquences Ci et Fi avec ces bits d'information tous donnés à zéro sauf les $i^{ièmes}$ bits d'information de la séquence décodée du code détecteur d'erreur, décode le code détecteur d'erreur de la séquence IK et mémorise le résultat sous la fome d'un bit de redondance de décodage Ri,j(i);

une troisième partie de traitement (155) pour appliquer le traitement logique suivant à toutes les combinaisons de candidats décodés et déterminer qu'un résultat du traitement logique devient un zéro:

$$R0\ ^{ER}R_{1,j(i)}\ ^{ER}R_{2,j(i)}\ ^{ER}R_{3,j(i)} \cdots \ ^{ER}R_{k,j(i)}$$

sachant que ER représente une somme logique exclusive bit-à-bit; et

une quatrième partie de traitement (156) qui, lorsque R0 ou un résultat d'un tel traitement logique est zéro, décide qu'un résultat du OU exclusif de IK0 et IK est un résultat décodé final sans erreur.

5. Système selon la revendication 1, caractérisé en ce que la partie de transmission (45, 145) inclut une partie de transmission radioélectrique (21, 22, 23, 24, 25, 45, 145) pour un système de radiocommunications de service mobile.

6. Système selon la revendication 3 ou 4, caractérisé en ce que l'unité de décodage avec correction d'erreur aléatoire (47, 147) inclut un moyen pour générer un nombre j2(i) de séquences Hi en inversant, à partir des séquences Di, les bits de fiabilité relativement basse et en appliquant un polynôme de génération du code cyclique à une séquence de ni bits comprenant des bits d'information non-inversés et des bits d'information inversés dans les séquences Di.

7. Système selon la revendication 3 ou 4, caractérisé en ce que l'unité de décodage avec correction d'erreur de salve (48, 148) comprend un moyen pour générer des séquences Hi correspondant aux séquences Ei en répétant, par un déplacement séquentiel de position de bit, le traitement pour choisir le nombre ni de bits d'information cycliquement continus parmi les séquences respectives Ei, le traitement pour générer les séquences E1i en appliquant le polynôme de génération du code cyclique aux bits d'information et le traitement pour générer les séquences E2i de ni bits correspondant aux séquences Bi en décalant cycliquement les séquences E1i, dans lequel

$$H1 = H_{1,1}, H_{1,2}, ...H_{1,j(1)}$$

$$H2 = H_{2,1}, H_{2,2}, ...H_{2,j(2)}$$

$$H3 = H_{3,1}, H_{3,2}, ...H_{3,j(3)}$$

..................... ..........

$$Hk = H_{k,1}, H_{k,2}, ...H_{k,j(k)}$$

8. Système selon la revendication 3 ou 4, caractérisé en ce que l'unité de décodage avec correction d'erreur de salve (48, 148) inclut un moyen pour générer un nombre j2(i) de séquences Hi, par un polynôme de génération du code cyclique, à partir de ni (indice n) bits cycliquement continus dans les séquences Ei et d'une séquence de ni bits obtenue à partir des bits de relativement faible fiabilité dans les séquences Ei, inversés.

9. Système selon la revendication 3 ou 4, caractérisé en ce que le moyen (49, 50, 51, 149, 150, 151) comprend une partie de synthèse (49, 149), une partie de décodage du code détecteur d'erreur (50, 150) et une partie de sélection par probabilité maximum (51, 151);

la partie de synthèse (49, 149) et la partie de sélection par probabilité maximum (51, 151) génèrent des premiers candidats décodés correspondant à la séquence Bi en sélectionnant à partir des séquences Fi et Hi,1, Hi,2, ...., Hi,j (i), et génèrent des second candidats décodés Ik correspondant à la séquence B en combinant ensemble les premiers candidats décodés; et

les k unités de décodage du code détecteur d'erreur (47, 147) génère un résultat décodé d'une séquence de bits d'information correspondant à la séquence A en réalisant un décodage de code détecteur d'erreur des second candidats décodés Ik.

10. Système selon la revendication 3, 4 ou 9, caractérisé en ce que

les k unités de décodage avec correction d'erreur aléatoire (47, 147) incluent un moyen pour générer un nombre f(i) de séquences Fi comme candidats décodés correspondant aux séquences Ei par décodage à décision pondérée utilisant une information de fiabilité obtenue du côté réception;

les k unités de décodage avec correction d'erreur de salve (48, 148) incluent un moyen pour générer un nombre j2(i) de séquences Hi, par un polynôme de génération du code cyclique, à partir de ni bits cycliquement continus dans les séquences Ei et d'une séquence de ni bits obtenues à partir des bits de fiabilité relativement faible dans les séquences Ei, inversés;

la partie de synthèse (49, 149) inclut un moyen pour générer un nombre (f(i)+j2(i)) de candidats décodés en tant que candidats décodés correspondant aux séquences Ei et pour générer des candidats décodés Ik correspondant à la séquence B en sélectionnant un nombre j3 (i) de candidats décodés parmi le nombre (f(i) +j2(i)) de candidats décodés suivant un ordre croissant de fiabilité; et

la partie de décodage de code détecteur d'erreur (50, 150) et la partie de sélection par probabilité maximum (51, 151) incluent un moyen qui, lorsqu'il n'est trouvé qu'un seul candidat décodé ne contenant aucune erreur lors du décodage du code détecteur d'erreur des candidats décodés, choisit son candidat décodé en tant que résultat décodé de la séquence de bits d'information et, lorsqu'une pluralité de candidats décodés se trouvent ne contenir aucune erreur, choisit un candidat décodé de fiabilité la plus élevée parmi ces candidats décodés, comme le résultat décodé de la séquence de bits d'information dans la séquence A, en comparant la fiabilité des candidats décodés.

11. Système selon la revendication 3 ou 4, caractérisé en ce qu'il comprend de plus une partie de contraction (149), prévue entre l'unité de décodage avec correction d'erreur aléatoire (147) et l'unité de décodage avec correction d'erreur de salve (148) d'une part et la partie de synthèse (150) d'autre part, la partie de contraction (149) étant d'un type tel que, afin de supprimer les candidats correspondant à la séquence B à $\Pi i(f3(1)+j3(1))$ avant de sélectionner un nombre j3(i) de candidats décodés parmi un nombre (f(i)+j2(i)) de candidats décodés dans un ordre de fiabilité croissante dans la partie de synthèse, la partie de contraction réduit le nombre f(i) de séquences Fi en un nombre f3(i) (f(i)≥f3(1)) et le nombre j2(i) de séquences Hi à j3(i) (j2(i)≥j3(i)).

**12.** Système selon la revendication 11, caractérisé en ce que la partie de contraction (149) inclut un moyen pour obtenir la fiabilité des $(f(i)+j2(i))$ candidats décodés et un moyen, afin de supprimer les candidats correspondants à la séquence B à $\Pi i(f3(i)+j3(i))$, pour réduire le nombre $f(i)$ de séquences Fi à $f3(i)$ $(f(i) \geq f3(i))$ et le nombre $j2(i)$ des séquences Hi à $j3(i)$ $(j2(i) \geq j3(i))$ selon le niveau et le niveau relatif de la fiabilité obtenue par le moyen d'obtention de fiabilité.

**13.** Système selon la revendication 3 ou 4, caractérisé en ce qu'il comprend de plus une partie de contraction (149) prévue entre l'unité de décodage avec correction d'erreur aléatoire (147) et l'unité de décodage avec correction d'erreur de salve (148) d'une part et la partie de synthèse (150) d'autre part, la partie de contraction étant d'un type tel que, afin de supprimer les candidats correspondant à un nombre prédéterminé inférieur à $\Pi i(f3(i)+j3(i))$ avant de sélectionner un nombre $j3(i)$ de candidats décodés parmi un nombre $(f(i)+j2(i))$ de candidats décodés dans la partie de synthèse dans un ordre croissant de fiabilité; la partie de contraction réduit le nombre $f(i)$ de séquences Fi à $f3(i)$ $(f(i) \geq f3(i))$ et le nombre $j2(i)$ de séquences Hi à $j3(i)$ $(j2(i) \geq j3(i))$.

**14.** Système selon la revendication 13, caractérisé en ce que la partie de contraction (149) inclut un moyen pour obtenir la fiabilité des $(f(i)+j2(i))$ candidats décodés et un moyen, afin de supprimer le nombre de candidats correspondant à la séquence B à $\Pi i(f3(i)+j3(i))$, pour réduire le nombre $f(i)$ de séquences Fi à $f3(i)$ $(f(i) \geq f3(1))$ et le nombre $j2(i)$ des séquences Hi à $j3(i)$ $(j2(i) \geq j3(i))$ selon le niveau et le niveau relatif de la fiabilité obtenue par le moyen d'obtention de fiabilité.

**15.** Système selon la revendication 1, caractérisé en ce que ledit moyen de décodage avec correction d'erreur aléatoire (47) et ledit moyen de décodage avec correction d'erreur de salve (48) présentent en sortie respectivement plusieurs candidats décodés et ledit décodeur (26, 30) comprend de plus un dispositif de sélection (51) pour choisir un candidat parmi lesdits plusieurs candidats décodés.

**16.** Système selon l'une quelconque des revendications 1 à 15, caractérisé en ce que ledit codeur (20, 27) comprend un codeur par code correcteur d'erreur CRC (41) et un codeur par code détecteur d'erreur BCH (43).

FIXED
NETWORK

10

11

CONTROL
SECTION

12    12    12

13

MOBILE
STATION

14

BASE STATION
-SIDE EQUIPMENT

TRANSMIT PATH

MOBILE STATION
-SIDE EQUIPMENT

F I G.   1

FIG. 2

INFORMATION BITS (53 BITS) ⋮ A SEQUENCE

20

41 — CRC CODING SECTION

B SEQUENCE (63)

42 — DIVIDING SECTION

B1 SEQUENCE (21)　　B2 SEQUENCE (21)　　B3 SEQUENCE (21)

43 — BCH (41, 21) CODING SECTION　　43 — BCH (41, 21) CODING SECTION　　43 — BCH (41, 21) CODING SECTION

C1 SEQUENCE (41)　　C2 SEQUENCE (41)　　C3 SEQUENCE (41)

INTERLEAVING (COMPOSING) SECTION — 44

D SEQUENCE (123)

RADIO TRANSMISSION SECTION — 45 (21, 22, 23, 24, 25, 28, 29)

26

E SEQUENCE (123)

DEINTERLEAVING (DECOMPOSING) / DIVIDING SECTION — 46

47　48　E1 SEQUENCE　47　(41)　48　E2 SEQUENCE　(41)　47　E3 SEQUENCE　48　(41)

| RANDOM ERROR CORRECTION DECODING SECTION | BURST ERROR CORRECTION DECODING SECTION | RANDOM ERROR CORRECTION DECODING SECTION | BURST ERROR CORRECTION DECODING SECTION | RANDOM ERROR CORRECTION DECODING SECTION | BURST ERROR CORRECTION DECODING SECTION |

F1 SEQUENCE (21)　H1 SEQUENCE (21)　F2 SEQUENCE (21)　H2 SEQUENCE (21)　F3 SEQUENCE (21)　H3 SEQUENCE (21)

SYNTHESIZING SECTION

49

Ik SEQUENCE (63)

CRC ERROR CORRECTION DECODING SEQUENCE — 50

SELECTION SECTION — 51

FIG. 3　　RESULT OF DECODING

i-th FRAME

i-th +1 FRAME

C2 SEQUENCE (41)

C1 SEQUENCE (41)

C3 SEQUENCE (41)

C2 SEQUENCE (41)

C1 SEQUENCE (41)

C3 SEQUENCE (41)

D SEQUENCE OF i-th FRAME

D SEQUENCE OF i-th +1 FRAME

: INFORMATION BITS (21 BITS)          : REDUNDANCY BITS (20 BITS)

F I G.  4

RESULT OF DECODING

51 — SELECTION SECTION

50 — CRC ERROR DETECTION DECODING

49

f(1)   j2(1)   f(2)   j2(2)   f(3)   j2(3)

47

47 — RANDOM ERROR CORRECTION DECODING

BURST ERROR CORRECTION DECODING

RANDOM ERROR CORRECTION DECODING

BURST ERROR CORRECTION DECODING

RANDOM ERROR CORRECTION DECODING

BURST ERROR CORRECTION DECODING

48   48   48

46B — DIVIDING SECTION

46

46A — DEINTERLEAVING SECTION

E SEQUENCE

( FROM RADIO TRANSMISSION )
 SECTION 45

F I G. 5

47

47B

47C  47D

Ei SEQUENCE
$\left(\begin{array}{l}\text{FROM DIVIDING} \\ \text{SECTION 46B}\end{array}\right)$

47A

| BIT INVERTING CKT |

| RANDOM ERROR CORRECTION DECODING CKT |

| RANDOM ERROR CORRECTION DECODING CKT |

| RANDOM ERROR CORRECTION DECODING CKT |

| RANDOM ERROR CORRECTION DECODING CKT |

ORDERING CKT

SELECTION CKT

$\left(\begin{array}{l}\text{TO SYNTHESIZING} \\ \text{SECTION 49}\end{array}\right)$

F I G.  6

F I G. 7

INFORMATION BITS (144BITS)

20'

141 — CRC CODING SECTION

B SEQUENCE (160)

142 — **DIVIDING SECTION**

B1 SEQUENCE (10)     B2 SEQUENCE (10)     B16 SEQUENCE (10)

BCH (14,10) CODING SECTION — 143     BCH (14,10) CODING SECTION — 143 ...     BCH (14,10) CODING SECTION — 143

144  C1 SEQUENCE (14)     C2 SEQUENCE (14)     C16 SEQUENCE (14)

INTERLEAVING SECTION

D SEQUENCE (224)

RADIO TRANSMISSION SECTION — 145 (21,22,23,24, 25,28,29)

26'

E SEQUENCE (224)

DEINTERLEAVING SECTION / DIVIDING SECTION — 46

E1 SEQUENCE     E2 SEQUENCE     E16 SEQUENCE
147   148  (14)     148   (14) 147     148  (14)

RANDOM ERROR CORRECTION DECODING SECTION | BURST ERROR CORRECTION DECODING SECTION | RANDOM ERROR CORRECTION DECODING SECTION | BURST ERROR CORRECTION DECODING SECTION | RANDOM ERROR CORRECTION DECODING SECTION | BURST ERROR CORRECTION DECODING SECTION

F1 SEQUENCE (10) | H1 SEQUENCE (10) | F2 SEQUENCE (10) | H2 SEQUENCE (10) | F16 SEQUENCE (10) | H16 SEQUENCE (10)

NARROWING-DOWN SECTION

149

SYNTHESIZING SECTION — 150

CRC ERROR DETECTION DECODING SECTION — 151

SELECTION SECTION — 152

F I G. 8     RESULT OF DECODING

F I G. 9

EP 0 588 307 B1

EP 0 588 307 B1

```
                                              146B                        147              149      150      151
                                                                                                                        152
                        146A
              ┌─────────────┐   ┌──────┐   ┌─────────────────────────┐  ┌──────┐ ┌──────┐ ┌──────────┐  ┌──────────┐
           ○──│DEINTERLEAVING│──│      │──┌│RANDOM ERROR CORRECTION  │  │      │ │      │ │          │  │          │──○
              │SECTION       │  │      │  ││DECODING SECTION         │  │      │ │      │ │          │  │          │
              └─────────────┘   │      │  │└─────────────────────────┘  │      │ │      │ │          │  │          │ RESULT OF DECODING
                                │      │  │        ┌────────────────┐   │      │ │      │ │          │  │          │
                                │      │  148│      │BURST ERROR CORRECTION│  │      │ │      │ │          │  │          │
                                │DIVIDING│  │     │DECODING SECTION │   │NARROWING-DOWN SECTION│ │SYNTHESIZING SECTION│ │CRC ERROR DETECTION DECODING SECTION│ │SELECTION SECTION│
                                │SECTION │  │      └────────────────┘   │      │ │      │ │          │  │          │
                                │      │  ┌│RANDOM ERROR CORRECTION  │  │      │ │      │ │          │  │          │
                                │      │  ││DECODING SECTION         │  │      │ │      │ │          │  │          │
                                │      │  │└─────────────────────────┘  │      │ │      │ │          │  │          │
                                │      │  │      │BURST ERROR CORRECTION│  │      │ │      │ │          │  │          │
                                │      │  │     │DECODING SECTION │   │      │ │      │ │          │  │          │
                                │      │  │      └────────────────┘   │      │ │      │ │          │  │          │
                                │      │         • • •                │      │ │      │ │          │  │          │
                                │      │  ┌│RANDOM ERROR CORRECTION  │  │      │ │      │ │          │  │          │
                                │      │  ││DECODING SECTION         │  │      │ │      │ │          │  │          │
                                │      │  │└─────────────────────────┘  │      │ │      │ │          │  │          │
                                │      │  │      │BURST ERROR CORRECTION│  │      │ │      │ │          │  │          │
                                │      │  │     │DECODING SECTION │   │      │ │      │ │          │  │          │
                                └──────┘  │      └────────────────┘   └──────┘ └──────┘ └──────────┘  └──────────┘
                                                                                CONDITION
```

# F I G. 10

F I G. 11

INFORMATION BITS (144 BITS)

20'

| 141 | CRC CODING SECTION |

B SEQUENCE (160)

| 142 | **DIVIDING SECTION** |

B1 SEQUENCE (10)    B2 SEQUENCE (10)    B16 SEQUENCE (10)

143 — BCH (14,10) CODING SECTION    143 — BCH (14,10) CODING SECTION    ...    BCH (14,10) CODING SECTION — 143

144    C1 SEQUENCE (14)    C2 SEQUENCE (14)    C16 SEQUENCE (14)

INTERLEAVING SECTION

D SEQUENCE (224)

RADIO TRANSMISSION SECTION — 145 (21, 22, 23, 24, 25, 28, 29)

26'

E SEQUENCE (224)

DEINTERLEAVING SECTION / DIVIDING SECTION — 46

E1 SEQUENCE (14)    E2 SEQUENCE (14)    E16 SEQUENCE (14)

147    148    147    148    147    148

RANDOM ERROR CORRECTION DECODING SECTION    BURST ERROR CORRECTION DECODING SECTION    RANDOM ERROR CORRECTION DECODING SECTION    BURST ERROR CORRECTION DECODING SECTION    RANDOM ERROR CORRECTION DECODING SECTION    BURST ERROR CORRECTION DECODING SECTION

F1 SEQUENCE (10)    H1 SEQUENCE (10)    F2 SEQUENCE (10)    H2 SEQUENCE (10)    F16 SEQUENCE (10)    H16 SEQUENCE (10)

1ST PROCESSING SECTION — 153

2ND PROCESSING SECTION — 154

3RD PROCESSING SECTION — 155

4TH PROCESSING SECTION — 156

RESULT OF DECODING

F I G. 12

EP 0 588 307 B1

F I G. 13

F I G. 14

F I G. 15